# EUROPEAN PATENT APPLICATION

(11) **EP 4 355 038 A1**
(43) Date of publication of application: **17.04.2024**
(21) Application number: 22820589.4
(22) Date of filing: 10.06.2022
(51) Int. Cl.: H05K 1/11, H05K 1/02, H05K 1/03, H01L 25/16, H01L 23/48, H01L 23/485, H01L 23/28

(54) **CIRCUIT BOARD AND SEMICONDUCTOR PACKAGE COMPRISING SAME**

(30) Priority: 10.06.2021 KR 20210075601; 23.07.2021 KR 20210097002
(71) Applicant: LG Innotek Co., Ltd., Seoul 07796 (KR)
(72) Inventor: BAE, Jae Man, Seoul 07796 (KR)
(74) Representative: Plasseraud IP
(86) International application number: PCT/KR2022/008175
(87) International publication number: WO 2022/260462

(57) **Abstract**

A circuit board according to an embodiment includes an insulating layer including an upper surface and a lower surface; and a through electrode passing through the upper and lower surfaces of the insulating layer, wherein the through electrode includes: a first electrode part disposed adjacent to the lower surface of the insulating layer and having a first inclination such that a width decreases toward the upper surface of the insulating layer; a second electrode part disposed on the first electrode part and having a second inclination such that a width increases toward the upper surface of the insulating layer; and a third electrode part disposed between the first electrode part and the second electrode part and having a third inclination different from the first and second inclinations; wherein a width of a portion of the first electrode part closest to the third electrode part is less than or equal to a width of the third electrode part, and wherein a width of a portion of the second electrode part closest to the third electrode part is smaller than or equal to a width of the third electrode part.

## Description

### [Technical Field]

The embodiment relates to a circuit board and a semiconductor package including the same.

### [Background Art]

As miniaturization, weight reduction, and integration of an electronic component are accelerated, a line width of a circuit has been miniaturized. In particular, as a design rule of a semiconductor chip is integrated on a nanometer scale, a circuit line width of a package substrate or a printed circuit board on which the semiconductor chip is mounted has been miniaturized to several micrometers or less.

Various methods have been proposed in order to increase the degree of circuit integration of the printed circuit board, that is, to reduce the circuit line width. For the purpose of preventing loss of the circuit line width in an etching step for forming a pattern after copper plating, a semi-additive process (SAP) method and a modified semi-additive process (MSAP) have been proposed.

Then, an embedded trace substrate (hereinafter referred to as "ETS") method for embedding a copper foil in an insulating layer in order to implement a fine circuit pattern has been used in the industry. In the ETS method, instead of forming a copper foil circuit on a surface of the insulating layer, the copper foil circuit is manufactured in an embedded form in the insulating layer, and thus there is no circuit loss due to etching and it is advantageous for miniaturizing the circuit pitch.

Meanwhile, recently, in order to meet a demand for wireless data traffic, efforts have been made to develop an improved 5G (5th generation) communication system or a pre-5G communication system. Here, the 5G communication system uses ultra-high frequency (mmWave) bands (sub 6GHz, 28GHz, 38GHz, or higher frequencies) to achieve high data transfer rates.

In addition, in order to reduce a path loss of radio waves and increase a transmission distance of radio waves in the ultra-high frequency band, in the 5G communication system, integration technologies such as beamforming, massive multi-input multi-output (massive MIMO), and array antennas have been developed. Considering that it may be composed of hundreds of active antennas of wavelengths in the frequency bands, an antenna system becomes large relatively.

Since such an antenna and AP module are patterned or mounted on the printed circuit board, low loss on the printed circuit board is very important. This means that several substrates constituting the active antenna system, that is, an antenna substrate, an antenna power feeding substrate, a transceiver substrate, and a baseband substrate, should be integrated into one compact unit.

On the other hand, such a circuit board includes a through electrode. The through electrode may perform various functions, for example, signal transmission, heat dissipation, and shielding functions. However, the conventional circuit board has various problems such as voids when a through electrode is formed in an insulating layer having a thickness of 300 µm or more.

### [Disclosure]

### [Technical Problem]

The embodiment provides a circuit board including a through electrode having a novel structure and a semiconductor package including the same.

In addition, the embodiment provides a circuit board including a through electrode including at least three side inflection portions and a semiconductor package including the same.

Also, the embodiment provides a circuit board capable of increasing an area of a central region of a through hole and a through electrode, and a semiconductor package including the same.

Technical problems to be solved by the proposed embodiments are not limited to the above-mentioned technical problems, and other technical problems not mentioned may be clearly understood by those skilled in the art to which the embodiments proposed from the following descriptions belong.

### [Technical Solution]

A circuit board according to an embodiment includes an insulating layer including an upper surface and a lower surface; and a through electrode passing through the upper and lower surfaces of the insulating layer, wherein the through electrode includes a first electrode part disposed adjacent to the lower surface of the insulating layer and having a first inclination such that a width decreases toward the upper surface of the insulating layer; a second electrode part disposed on the first electrode part and having a second inclination such that a width increases toward the upper surface of the insulating layer; and a third electrode part disposed between the first electrode part and the second electrode part and having a third inclination different from the first and second inclinations; wherein a width of a portion of the first electrode part closest to the third electrode part is smaller than a width of the third electrode part; and wherein a width of a portion of the second electrode part closest to the third electrode part is smaller than a width of the third electrode part.

In addition, a circuit board according to the embodiment includes an insulating layer including an upper surface and a lower surface, and a through hole passing through the upper surface and the lower surface, wherein the through hole includes: a first hole part disposed adjacent to the lower surface of the insulating layer and having a first inclination to decrease in width toward the upper surface of the insulating layer; a second hole part disposed on the first hole part and having a second inclination to increase in width toward the upper surface; and a third hole part disposed between the first hole part and the second hole part and having a third inclination different from the first and second inclinations; wherein a width of a portion of the first hole part closest to the third hole part is smaller than a width of the third hole part, and wherein a width of a portion of the second hole part closest to the third hole part is smaller than a width of the third hole part.

In addition, the circuit board further comprises a through electrode passing through the insulating layer and corresponding to the through hole; wherein the through electrode includes: a first electrode part corresponding to the first hole part; a second electrode part corresponding to the second hole part; and a third electrode part corresponding to the third hole part.

In addition, the circuit board further comprises: a first pad disposed on the lower surface of the insulating layer and connected to the first electrode part; and a second pad disposed on the upper surface of the insulating layer and connected to the second electrode part.

In addition, a width of a portion of the first electrode part closest to the first pad is smaller than a width of the first pad; and wherein a width of a portion of the second electrode part closest to the second pad is smaller than a width of the second pad.

In addition, a width of an upper surface of the third electrode part satisfies a range of 95% to 105% of a width of a lower surface of the third electrode part.

In addition, the third inclination is perpendicular to the upper surface or the lower surface of the insulating layer.

In addition, the first electrode part and the second electrode part have a mutually symmetrical shape with respect to the third electrode part.

In addition, the first inclination the second inclination are inclined in different directions.

In addition, a thickness of the insulating layer is 300*µ*m or more.

In addition, the insulating layer includes: a first insulating part in which the first electrode part is disposed; a second insulating part in which the second electrode part is disposed; and a third insulating part in which the third electrode part is disposed.

In addition, the first to third insulating parts include the same insulating material as each other.

In addition, the insulating material includes a prepreg.

In addition, a thickness of each of the first insulating part and the second insulating part has a range between 35% and 65% of a thickness of the third insulating part.

In addition, the first electrode part has a trapezoidal shape in which a width of a lower surface of the first electrode part is greater than a width of an upper surface of the first electrode part, wherein the second electrode part has a trapezoidal shape in which a width of a lower surface of the second electrode part is smaller than a width of an upper surface of the second electrode part, and wherein the third electrode part has a rectangular shape in which a width of a lower surface of the third electrode part and a width of an upper surface of the third electrode part.

Meanwhile, a semiconductor package according to an embodiment includes a circuit board including a mounting pad; a connection portion disposed on the mounting pad of the circuit board; a chip disposed on the connection portion; and a molding layer for molding the chip; wherein the circuit pad includes: an insulating layer including an upper surface and a lower surface; and a through electrode passing through the upper and lower surfaces of the insulating layer, wherein the through electrode includes a first electrode part disposed adjacent to the lower surface of the insulating layer and having a first inclination such that a width decreases toward the upper surface of the insulating layer; a second electrode part disposed on the first electrode part and having a second inclination such that a width increases toward the upper surface of the insulating layer; and a third electrode part disposed between the first electrode part and the second electrode part and having a third inclination different from the first and second inclinations; wherein a width of a portion of the first electrode part closest to the third electrode part is smaller than a width of the third electrode part; wherein a width of a portion of the second electrode part closest to the third electrode part is smaller than a width of the third electrode part, wherein the chip includes a first chip and a second chip disposed to be spaced apart from each other in a width direction, wherein the first chip corresponds to a central processor (CPU), and wherein the second chip corresponds to a graphic processor (GPU).

A circuit board according to an embodiment includes an insulating layer including an upper surface and a lower surface; and a through electrode passing through the upper and lower surfaces of the insulating layer, wherein the through electrode includes: a first electrode part disposed adjacent to the lower surface of the insulating layer and having a first inclination such that a width decreases toward the upper surface of the insulating layer; a second electrode part disposed on the first electrode part and having a second inclination such that a width increases toward the upper surface of the insulating layer; and a third electrode part disposed between the first electrode part and the second electrode part and having a third inclination different from the first and second inclinations; wherein a width of a portion of the first electrode part closest to the third electrode part is equal to a width of the third electrode part, and wherein a width of a portion of the second electrode part closest to the third electrode part is equal to a width of the third electrode part.

On the other hand, a circuit board according to another embodiment includes an insulating layer including an upper surface and a lower surface, and a through hole passing through the upper surface and the lower surface, wherein the through hole includes: a first hole part disposed adjacent to the lower surface of the insulating layer and having a first inclination to decrease in width toward the upper surface of the insulating layer; a second hole part disposed on the first hole part and having a second inclination to increase in width toward the upper surface; and a third hole part disposed between the first hole part and the second hole part and having a third inclination different from the first and second inclinations; wherein a width of a portion of the first hole part closest to the third hole part is equal to a width of the third hole part, and wherein a width of a portion of the second hole part closest to the third hole part is equal to a width of the third hole part.

In addition, the circuit board further includes a through electrode passing through the insulating layer and corresponding to the through hole; wherein the through electrode includes: a first electrode part corresponding to the first hole part; a second electrode part corresponding to the second hole part; and a third electrode part corresponding to the third hole part.

In addition, a width of and upper surface of the third electrode part is the same as a width of a lower surface of the third electrode part, wherein the width of the lower surface of the third electrode part is the same as a width of a region having a smallest width in the first electrode part, and the width of the upper surface of the third electrode part is the same as a width of a region having a small width in the second electrode part.

In addition, the insulating layer includes a first region in which the first electrode part is disposed; a second region in which the second electrode part is disposed; a third region in which the third electrode part is disposed; and wherein a density of a glass fiber in the third region is greater than a density of a glass fiber in each of the first and second regions.

In addition, the insulating layer includes a first insulating part and a second insulating part on the first insulating part; wherein the first insulating part includes a first-first region adjacent to the lower surface of the insulating layer; and a first-second adjacent to the lower surface of the insulating layer; wherein the second insulating part includes a second-first region adjacent to the lower surface of the insulating layer; and a second-second adjacent to the upper surface of the insulating layer; wherein the first region of the insulating layer corresponds to the first-first region of the first insulating part, wherein the second region of the insulating layer corresponds to the second-first region of the second insulating part, and the third region of the insulating layer corresponds to the first-second region of the first insulating part and the second-first region of the second insulating part.

In addition, the circuit board further includes a first pad disposed on the lower surface of the insulating layer and connected to the first electrode part; and a second pad disposed on the upper surface of the insulating layer and connected to the second electrode part.

In addition, a width of a portion of the first electrode part closest to the first pad is smaller than a width of the first pad, and a width of a portion of the second electrode part closest to the second pad is smaller than a width of the second pad.

In addition, a width of an upper surface of the third electrode part satisfies a range of 95% to 105% of a width of a lower surface of the third electrode part.

In addition, the third inclination is perpendicular to the upper surface or the lower surface of the insulating layer.

In addition, the first electrode part and the second electrode part have a mutually symmetrical shape with respect to the third electrode part.

In addition, the first inclination the second inclination are inclined in different directions.

In addition, the insulating layer includes a prepreg including a resin and glass fiber.

In addition, the first electrode part has a trapezoidal shape in which a width of a lower surface of the first electrode part is greater than a width of an upper surface of the first electrode part, wherein the second electrode part has a trapezoidal shape in which a width of a lower surface of the second electrode part is smaller than a width of an upper surface of the second electrode part, and wherein the third electrode part has a rectangular shape in which a width of a lower surface of the third electrode part and a width of an upper surface of the third electrode part.

Meanwhile, a semiconductor package according to an embodiment includes a circuit board including a mounting pad; a connection portion disposed on the mounting pad of the circuit board; a chip disposed on the connection portion; and a molding layer for molding the chip; wherein the circuit pad includes: an insulating layer including an upper surface and a lower surface; and a through electrode passing through the upper and lower surfaces of the insulating layer, wherein the through electrode includes: a first electrode part disposed adjacent to the lower surface of the insulating layer and having a first inclination such that a width decreases toward the upper surface of the insulating layer; a second electrode part disposed on the first electrode part and having a second inclination such that a width increases toward the upper surface of the insulating layer; and a third electrode part disposed between the first electrode part and the second electrode part and having a third inclination different from the first and second inclinations; wherein a width of a portion of the first electrode part closest to the third electrode part is equal to a width of the third electrode part, wherein a width of a portion of the second electrode part closest to the third electrode part is equal to a width of the third electrode part, wherein the chip includes a first chip and a second chip disposed to be spaced apart from each other in a width direction, wherein the first chip corresponds to a central processor (CPU), and wherein the second chip corresponds to a graphic processor (GPU).

### [Advantageous Effects]

When a through electrode is formed in an insulating layer that is a core layer of a certain thickness or more (for example, 300 µm or more), the embodiment divides the insulating layer into a plurality of insulating parts (eg, first to third insulating parts), and accordingly, electrode parts (eg, first to third electrode parts) passing through each of the insulating parts are formed. In addition, after first forming the third electrode part constituting the through electrode through a post plating process, a final through electrode of the embodiment is formed by forming the first electrode part and the second electrode part on the lower and upper portions of the third electrode part, respectively. That is, the third electrode part corresponding to the center of the through electrode in the embodiment is first formed by applying the post plating method, and then the first electrode part and the second electrode part are respectively formed under and one the third electrode part. Accordingly, the embodiment may prevent an empty space not filled in the electrode portion of the through electrode from being generated. Accordingly, the embodiment prevents problems such as voids or dimples from occurring in the through electrode, thereby improving the physical reliability and electrical reliability of the through electrode.

In addition, the third electrode part disposed at the center of the plurality of electrode parts constituting the through electrode according to the embodiment is formed through a post plating process, and thus the width of the upper surface and the lower surface is substantially the same. Accordingly, the embodiment can increase the area of the through electrode compared to the through electrode having the hourglass shape of the comparative example, and thus the effect according to the function of the through electrode can be maximized. For example, when the through electrode has a signal shielding function, the signal shielding effect may be further improved. For example, when the through electrode has a heat dissipation function, heat dissipation characteristics may be further improved.

Furthermore, the glass fiber may be partially exposed in the central region of the through hole of the embodiment by including a dense region of glass fibers in the central region of the insulating layer. In addition, the through electrode of the embodiment may be formed while covering the glass fiber exposed through the through hole. In this case, the exposed glass fibers function to increase the roughness of the inner wall of the through hole, and thus, the bonding force between the insulating layer and the through electrode can be improved when the through electrode is formed. Accordingly, in the embodiment, it is possible to solve the problem that the through electrode is separated from the insulating layer due to warpage occurring in various usage environments of the circuit board, and thus the physical reliability and electrical reliability of the circuit board can be improved.

### [Description of Drawings]

FIG. 1A is a view for explaining a problem of a circuit board according to a first comparative example.
FIG.1B is a view for explaining a problem of a circuit board according to a second comparative example.
FIGS. 2 and 3 are views showing a circuit board according to a first embodiment.
FIG. 4A is a view for explaining inclinations of side surfaces of a first electrode part and a second electrode part according to an embodiment.
FIG. 4B is a view for explaining an inclination of a side surface of a third electrode part according to an embodiment.
FIG. 5 is a view showing a circuit board according to a second embodiment.
FIG. 6 is a view showing a circuit board according to a third embodiment.
FIG. 7 is a view showing a circuit board according to a fourth embodiment.
FIG. 8 is a view for explaining the insulating layer of FIG. 6.
FIG. 9 is a view for explaining the through electrode formed in FIG. 6 or FIG. 7.
FIG. 10 is a view showing a semiconductor package according to an embodiment.
FIGS. 11 to 24 are views showing the manufacturing method of the circuit board shown in FIG. 2 in order of process.

### [Best Mode]

Hereinafter, embodiments of the present disclosure will be described in detail with reference to the accompanying drawings.

However, the spirit and scope of the present disclosure is not limited to a part of the embodiments described, and may be implemented in various other forms, and within the spirit and scope of the present disclosure, one or more of the elements of the embodiments may be selectively combined and replaced.

In addition, unless expressly otherwise defined and described, the terms used in the embodiments of the present disclosure (including technical and scientific terms) may be construed the same meaning as commonly understood by one of ordinary skill in the art to which the present disclosure belongs, and the terms such as those defined in commonly used dictionaries may be interpreted as having a meaning that is consistent with their meaning in the context of the relevant art. In addition, the terms used in the embodiments of the present disclosure are for describing the embodiments and are not intended to limit the present disclosure.

In this specification, the singular forms may also include the plural forms unless specifically stated in the phrase, and may include at least one of all combinations that may be combined in A, B, and C when described in "at least one (or more) of A (and), B, and C". Further, in describing the elements of the embodiments of the present disclosure, the terms such as first, second, A, B, (a), and (b) may be used.

These terms are only used to distinguish the elements from other elements, and the terms are not limited to the essence, order, or order of the elements. In addition, when an element is described as being "connected", "coupled", or "connected" to another element, it may include not only when the element is directly "connected" to, "coupled" to, or "connected" to other elements, but also when the element is "connected", "coupled", or "connected" by another element between the element and other elements.

In addition, when described as being formed or disposed "on (over)" or "under (below)" of each element, the "on (over)" or "under (below)" may include not only when two elements are directly connected to each other, but also when one or more other elements are formed or disposed between two elements. Further, when expressed as "on (over)" or "under (below)", it may include not only the upper direction but also the lower direction based on one element.

### -Comparative example (Structure and problems of the prior art)-

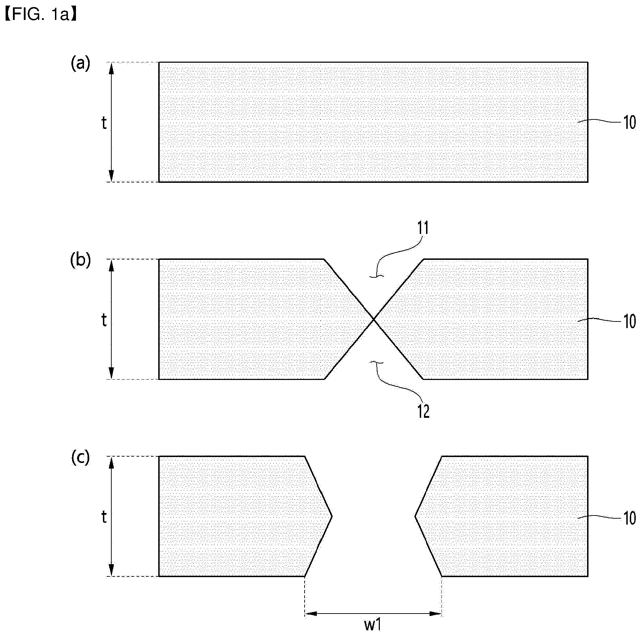

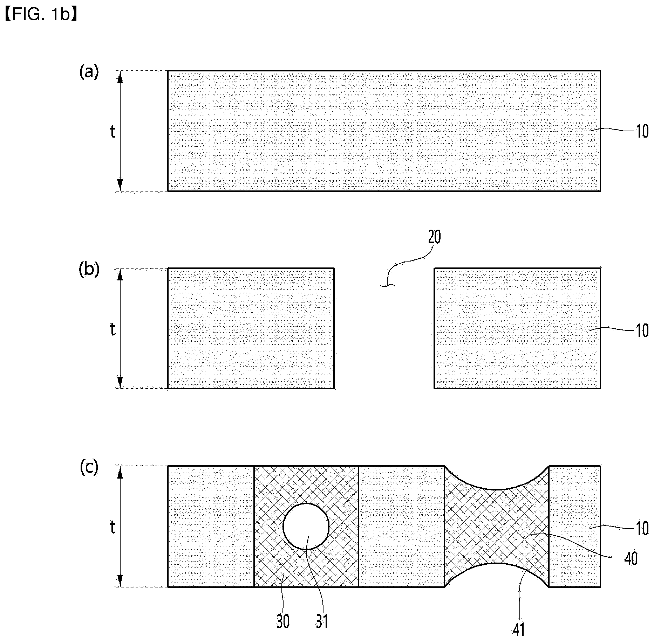

FIG. 1A is a view for explaining a problem of a circuit board according to a first comparative example, and FIG.1B is a view for explaining a problem of a circuit board according to a second comparative example

Hereinafter, problems of the circuit board according to the comparative example will be described with reference to FIGS. 1A to 1B.

Before explaining the comparative example, high density of circuit boards is required along with high functionalization of electronic devices and high integration of semiconductor devices. Accordingly, the circuit board has a multilayer structure.

A product group to which such a multi-layered circuit board is applied includes Flip Chip Ball Grid Array (FCBGA) and Flip-Chip Chip Scale Package (FCCSP). And, a circuit board applied to FCBGA or FCCSP includes a core layer. In addition, the core layer has a thickness of 300 µm or more to realize multi-layer build-up. In addition, a through electrode is formed in the core layer for conduction of circuit patterns of each layer. The through electrode may be formed by filling through holes passing through upper and lower surfaces of the core layer with a conductive material. However, the core layer as described above has a thickness of 300 µm or more, and thus the process of forming the through hole and/or the through electrode of the comparative example has the following problems.

As shown in (a) of FIG. 1A, in the first comparative example, an insulating layer 10 to be used as a core layer is prepared. In this case, a thickness (t) of the insulating layer 10 may be 300 µm or more.

In the first comparative example, a through hole may be formed in the insulating layer 10 by laser processing. At this time, as the insulating layer 10 has a thickness (t) of 300 µm or more, it is difficult to process the through-hole only on one side of the insulating layer 10. Accordingly, in general, when a through-hole is formed in the insulating layer 10 such as a core layer using a laser, a process of forming through-holes on the upper and lower surfaces of the insulating layer 10 is performed, respectively.

For example, when forming a through hole in the insulating layer 10 by laser processing, a process of forming the first hole part of the through hole on the upper surface of the insulating layer 10 to correspond to the target size of the through hole and a process of forming a second hole part connected to the first hole part of the through hole on the lower surface of the insulating layer 10 is performed.

However, as in (b) of FIG. 1A, when the first hole part 11 and the second hole part 12 are formed to correspond to the target size as described above, a non-passing problem occurs in that the first hole part 11 and the second hole part 12 are not connected to each other.

Accordingly, in the first comparative example, as in (c) of FIG. 1A, the first hole part and the second hole part are formed to have a size larger than a target size of the through hole in order to solve the non-passage problem. However, when performing such a process, the through hole has a width w1 greater than the target size. Accordingly, there is a problem in that it is difficult to adjust the size of the through hole and the through electrode formed by filling the through hole in the first comparative example to a desired target size. Furthermore, when the process of filling the inside of the through hole with a conductive material is performed, plating problems such as voids (a phenomenon in which a part of the through-hole is not filled) or dimples (a phenomenon in which the upper or lower surface of the through-electrode is dented) occur due to the increase in the size of the through-hole.

Also, as in (a) and (b) of FIG. 1B, the second comparative example forms the through hole 20 in the insulating layer 10 by using a CNC (computer numerical control) drill instead of a laser. And, the through hole 20 has the same width as the width of the upper surface and the lower surface in the case of using a CNC drill. And, the through-hole 20 of the second comparative example is filled with a conductive material to form a through-electrode. In this case, the through hole 20 of the second comparative example has a columnar shape having the same width on the upper surface and the lower surface. However, the through hole 20 does not include a plating bridge, unlike the through hole of FIG. 1A having an hourglass shape. Accordingly, there is a problem in that it is difficult to uniformly fill the conductive material in the through hole 20. For example, as shown in (c) of FIG. 1B, the plating of the first through electrode 30 formed in the through hole 20 is completed at the outside of the through hole rather than the center of the through hole 20. Accordingly, there is a problem in that an empty space 31 that is not plated is present in the center. For example, the second through electrode 40 formed in the through hole 20 has a problem in that the upper and lower surfaces include dimple portions having curved surfaces (for example, a curved surface concave toward the center) rather than flat surfaces. To solve this problem, the inside of the through hole 20 of the second comparative example is filled in a hole plugging method. However, the hole plugging method includes a plurality of plating processes and a hole plugging process, and thus there is a problem in that the plating process is increased. In addition, the hole plugging process has a problem in that a portion of the inside of the through hole is not filled by performing hole plugging using plate making. In this case, the hole plugging process is a method of filling a part of the through hole using copper and filling the remaining part using a filler. However, the filler is made of a material different from the prepreg constituting the insulating layer 10 and the copper. Accordingly, the circuit board manufactured using the hole plugging method has a structure vulnerable to distortion due to a difference in coefficient of thermal expansion between the prepreg, the copper, and the filler, and thus easily cracks.

Accordingly, the embodiment enables the formation of a through electrode having improved electrical reliability and physical reliability in the through hole formed in the core layer having a thickness of 300 µm or more. For example, the embodiment provides a circuit board including a through electrode having a new structure and a semiconductor package including the same.

### -Electronic device-

Before describing an embodiment, a semiconductor package having a structure in which a chip is mounted on the circuit board of the embodiment may be included in an electronic device.

In this case, the electronic device includes a main board (not shown). The main board may be physically and/or electrically connected to various components. For example, the main board may be connected to the semiconductor package of the embodiment. Various chips may be mounted on the semiconductor package. Broadly, a memory chip such as a volatile memory (eg, DRAM), a non-volatile memory (eg, ROM), and a flash memory, an application processor chip such as a central processor (eg, CPU), a graphics processor (eg, GPU), a digital signal processor, an encryption processor, a microprocessor, and a microcontroller, and a logic chip such as an analog-to-digital converter and an ASIC (application-specific IC) may be mounted on the semiconductor package.

Further, the embodiment provides a semiconductor package capable of mounting at least two different types of chips on one substrate while reducing the thickness of the semiconductor package connected to the main board of the electronic device.

In this case, the electronic device may include a smart phone, a personal digital assistant, a digital video camera, a digital still camera, a network system, a computer, a monitor, a tablet, a laptop, a netbook, a television, a video game, a smart watch, an automotive, and the like. However, the embodiment is not limited thereto, and may be any other electronic device that processes data in addition to these.

### - Circuit board of a first embodiment-

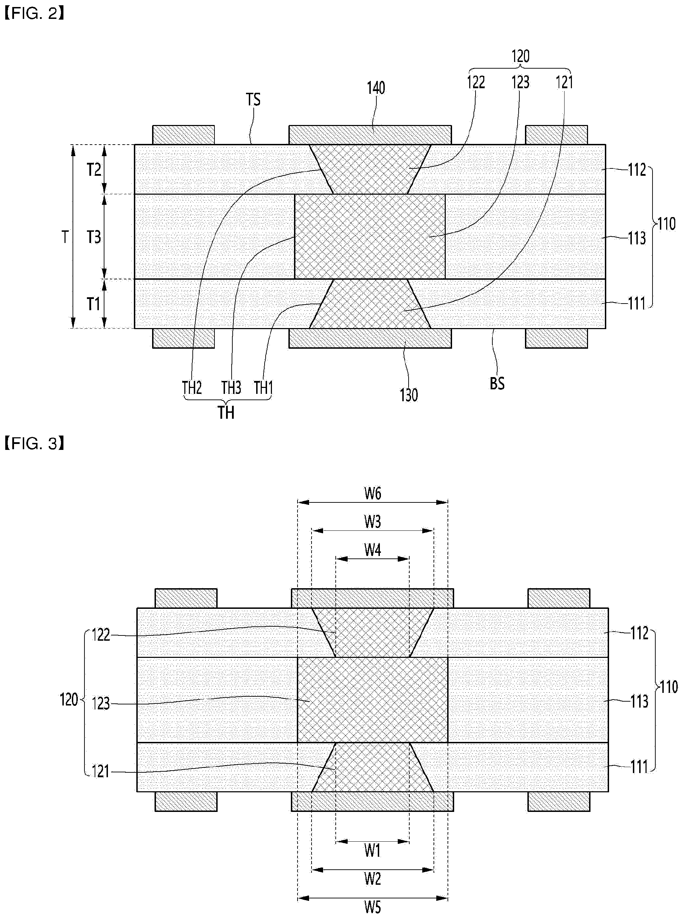

FIGS. 2 and 3 are views showing a circuit board according to a first embodiment. Specifically, FIG. 2 is a view for explaining the overall structure of the core layer in the circuit board according to the embodiment, and FIG. 3 is a view for explaining the structure of a through electrode included in the core layer according to the first embodiment in detail.

FIGS. 2 and 3, the circuit board includes an insulating layer 110, a through electrode 120, a first pattern layer 130, and a second pattern layer 140.

The circuit board of the embodiment may have a multi-layer structure. For example, the circuit board of the embodiment may include a plurality of insulating layers. However, FIGS. 2 and 3 may show a core layer in a circuit board having a multilayer structure. In addition, the through electrode 120 of the embodiment may be formed to pass through the insulating layer 110 that is the core layer.

The insulating layer 110 may be a core layer. For example, the insulating layer 110 may include a prepreg. The insulating layer 110 may increase the physical strength of the circuit board to improve warpage characteristics.

The prepreg of the insulating layer 110 of the embodiment may be formed by impregnating a fiber layer in the form of a fabric sheet, such as a glass fabric woven with glass yarn, with an epoxy resin, and then performing thermocompression. However, the embodiment is not limited thereto, and the prepreg constituting the insulating layer 110 may include a fiber layer in the form of a fabric sheet woven with carbon fiber yarn.

Specifically, the insulating layer 110 may include a resin and a reinforcing fiber disposed in the resin. The resin may be an epoxy resin, but is not limited thereto. The resin is not particularly limited to the epoxy resin, and for example, one or more epoxy groups may be included in the molecule, or alternatively, two or more epoxy groups may be included, or alternatively, four or more epoxy groups may be included. In addition, the resin of the insulating layer 110 may include a naphthalene group, for example, may be an aromatic amine type, but is not limited thereto. For example, the resin may be include a bisphenol A type epoxy resin, a bisphenol F type epoxy resin, a bisphenol S type epoxy resin, a phenol novolac type epoxy resin, an alkylphenol novolac type epoxy resin, a biphenyl type epoxy resin, an aralkyl type epoxy resin, dicyclopentadiene type epoxy resin, naphthalene type epoxy resin, naphthol type epoxy resin, epoxy resin of condensate of phenol and aromatic aldehyde having phenolic hydroxyl group, biphenyl aralkyl type epoxy resin, fluorene type epoxy resin resins, xanthene-type epoxy resins, triglycidyl isocyanurate, rubber-modified epoxy resins, phosphorous-based epoxy resins, and the like, and naphthalene-based epoxy resins, bisphenol A-type epoxy resins, and phenol novolac epoxy resins, cresol novolak epoxy resins, rubber-modified epoxy resins, and phosphorous-based epoxy resins. In addition, the reinforcing fiber may include glass fiber, carbon fiber, aramid fiber (eg, aramid-based organic material), nylon, silica-based inorganic material or titania-based inorganic material. The reinforcing fibers may be arranged in the resin to cross each other in a planar direction.

Meanwhile, the glass fiber, carbon fiber, aramid fiber (eg, aramid-based organic material), nylon, silica-based inorganic material or titania-based inorganic material may be used.

The insulating layer 110 of the embodiment may be divided into a plurality of parts. For example, the insulating layer 110 may include a first insulating part 111, a second insulating part 112, and a third insulating part 113 in a thickness direction. Here, although the insulating layer 110 includes a first insulating part 111, a second insulating part 112, and a third insulating part 113, it may substantially constitute one insulating layer.

For example, the insulating layer 110 includes an upper surface (TS, Upper surface) and a lower surface (BS, Lower surface). In addition, the first pattern layer 130 and the second pattern layer 140 may be respectively disposed on the lower surface BS and the upper surface TS of the insulating layer 110. Here, the lower surface BS of the insulating layer 110 may mean any one of a lower surface of the first insulating part 111, a lower surface of the second insulating part 112, and a lower surface of the third insulating part 113. In addition, the upper surface TS of the insulating layer 110 may mean any one of the upper surface of the first insulating part 111, the upper surface of the second insulating part 112, and the upper surface of the third insulating part 113. Specifically, the lower surface BS of the insulating layer 110 may mean a lower surface of the first insulating part 111. In addition, the upper surface TS of the insulating layer 110 may mean an upper surface of the second insulating part 112.

In addition, the fact that one insulating layer 110 is substantially composed of the first insulating part 111, the second insulating part 112 and the third insulating part 113 may mean that no pattern layer is formed on surfaces other than the lower surface of the first insulating part 111 and the upper surface of the second insulating part 112. For example, a pattern layer may not be formed on the upper surface of the first insulating part 111, the lower surface of the second insulating part 112, and the upper and lower surfaces of the third insulating part 113.

A thickness T of the insulating layer 110 may be 300 µm or more. The thickness T of the insulating layer 110 may be 350 µm or more. The thickness T of the insulating layer 110 may be 400 µm or more. That is, the insulating layer 110 is a core layer, and thus may have a thickness of at least 300 µm or more in order to improve the warpage characteristics of the circuit board in the packaging process while increasing the physical rigidity of the circuit board. And, in the embodiment, as described above, when the thickness T of the insulating layer 110 is 300 µm or more, the insulating layer 110 is divided into three insulating parts. Specifically, in the embodiment, when the thickness T of the insulating layer 110 is 300 µm or more, the insulating layer 110 is divided into 3 divided into parts in order to improve the physical reliability and electrical reliability of the through electrode 120 passing therethrough. However, the embodiment is not limited thereto, and even when the thickness T of the insulating layer 110 is less than 300 µm, it is divided into three parts, and accordingly, the through electrode 120 including first to third electrode parts (to be described later) passing through each of the three insulating parts may be formed. However, an effect that appears as the insulating layer 110 of the embodiment is divided into a plurality of insulating parts and the through electrode 120 is formed on the plurality of insulating parts is maximized when the insulating layer 110 has a thickness of 300 µm or more. Accordingly, in the following description, it is assumed that the insulating layer 110 has a thickness T of 300 µm or more.

The first insulating part 111, the second insulating part 112, and the third insulating part 113 constituting the insulating layer 110 may have different thicknesses. For example, the first insulating part 111 may have a smaller thickness than the third insulating part 113. For example, the second insulating part 112 may have a smaller thickness than the third insulating part 113. In addition, thicknesses of the first insulating part 111 and the second insulating part 112 may correspond to each other.

The first insulating part 111 may have a first thickness T1 in a range of 75 µm to 150 µm. For example, the first insulating part 111 may have a first thickness T1 in a range of 80 µm to 130 µm. For example, the first insulating part 111 may have a first thickness T1 in a range of 90 µm to 120 µm. When the first insulating part 111 is less than 75 µm, the meaning of dividing the insulating layer 110 into three insulating parts is lost. In other words, when the first insulating part 111 is less than 75 µm, even if the through electrode 120 described below is not divided into a plurality of electrode parts, a problem may not occur in the physical and electrical reliability of the through electrode. For example, when the first insulating part 111 is less than 75 µm, the thickness of the second insulating part 112 or the third insulating part 113 increases correspondingly, and accordingly, a problem may occur in electrical or physical reliability of the electrode part formed on the second insulating part 112 or the third insulating part 113. When the thickness of the first insulating part 111 exceeds 150 µm, there is a problem in electrical or physical reliability of the first electrode part 121 of the through electrode 120 passing through the first insulating part 111 (For example, voids or dimples may occur). For example, when the thickness of the first insulating part 111 exceeds 150 µm, there may be a problem that the first electrode part 121 passing through the first insulating part 111 includes voids or dimples.

The second insulating part 112 may have a second thickness T2 corresponding to the first insulating part 111. For example, the second insulating part 112 may have a second thickness T2 in a range of 75 µm to 150 µm. For example, the second insulating part 112 may have a second thickness T2 in a range of 80 µm to 130 µm. For example, the second insulating part 112 may have a second thickness T2 in a range of 90 µm to 120 µm. When the second insulating part 112 is less than 75 µm, the thickness of the first insulating part 111 or the third insulating part 113 increases correspondingly, and accordingly, a problem may occur in electrical or physical reliability of the electrode part formed on the first insulating part 111 or the third insulating part 113. When the thickness of the second insulating part 112 exceeds 150 µm, there is a problem in electrical or physical reliability of the second electrode part 122 of the through electrode 120 passing through the second insulating part 112 (For example, voids or dimples may occur). When the thickness of the second insulating part 112 exceeds 150 µm, there may be a problem that the second electrode part 122 passing through the second insulating part 112 includes voids or dimples.

The third insulating part 113 may have a third thickness T3 greater than the first thickness T1 of the first insulating part 111 or the second thickness T2 of the second insulating part 112. For example, the third insulating part 113 may have a third thickness T3 in a range of 150 µm to 300 µm. For example, the third insulating part 113 may have a third thickness T3 in the range of 165 µm to 280 µm. For example, the third insulating part 113 may have a third thickness T3 in a range of 180 µm to 250 µm. When the thickness of the third insulating part 113 is less than 150 µm, the thickness of the first insulating part 111 or the second insulating part 112 increases correspondingly, and accordingly, voids or dimples may be included in the first electrode part 121 or the second electrode part 122 passing through the first insulating part 111 or the second insulating part 112. Also, when the third insulating part 113 exceeds 300 µm, the number of processes in the process of forming the third electrode part 123 passing through the third insulating part 113 may increase. For example, when the third insulating part 113 exceeds 300 µm, the thickness of the third electrode part 123 also exceeds 300 µm, and accordingly, there is a problem in that a plurality of plating processes must be performed in order to form the third electrode part 123 exceeding 300 µm. Specifically, the third electrode part 123 is formed through a post plating process. In this case, the thickness of the post corresponding to the third electrode part 123 that can be formed by one plating process is about 300 µm. Accordingly, when the third electrode part 123 exceeds 300 µm, a plurality of post-plating processes must be performed, thereby complicating the manufacturing process.

Meanwhile, the first insulating part 111, the second insulating part 112, and the third insulating part 113 are determined by the thickness T of the insulating layer 110. Accordingly, the thickness of each of the first insulating part 111 and the second insulating part 112 may be in a range of 35% to 65% of the thickness of the third insulating part 113. For example, the thickness of each of the first insulating part 111 and the second insulating part 112 may be 38% to 62% of the third insulating part 113. For example, the thickness of each of the first insulating part 111 and the second insulating part 112 may be in a range of 40% to 58% of the third insulating part 113. And, when the thickness of each of the first insulating part 111 and the second insulating part 112 is out of the range of 35% to 65% of the third insulating part 113, the physical or Electrical reliability issues may occur.

The circuit board of the embodiment includes a through electrode 120 passing through the insulating layer 110. For example, the through electrode 120 includes a first electrode part 121 passing through the first insulating part 111, a second electrode part 122 passing through the second insulating part 112, and the and a third electrode part 123 passing through the third insulating part 113.

Specifically, the first electrode part 121 is disposed adjacent to the lower surface BS of the insulating layer 110 and may have a first inclination such that a width gradually decreases toward the upper surface TS of the insulating layer 110. The first inclination may mean an inclination of a side surface of the first electrode part 121 with respect to the lower surface BS of the insulating layer 110. Alternatively, the first inclination may mean an inclination of the side surface of the first electrode part 121 with respect to the upper surface TS of the insulating layer 110.

Also, the second electrode part 122 may be disposed on the first electrode part 121. For example, the second electrode part 122 may be disposed adjacent to the upper surface TS of the insulating layer 110. The second electrode part 122 may have a second inclination such that its width gradually increases toward the upper surface TS of the insulating layer 110. That is, the second electrode part 122 may have a second inclination different from the first inclination of the first electrode part 121. The second inclination may mean an inclination of a side surface of the second electrode part 122 with respect to the lower surface of the insulating layer 110. Alternatively, the second inclination may mean an inclination of the side surface of the second electrode part 122 with respect to the upper surface of the insulating layer 110.

In other words, the first inclination of the side surface of the first electrode part 121 with respect to the lower surface BS of the insulating layer 110 may be different from the second inclination of the side surface of the second electrode part 122 with respect to the lower surface BS of the insulating layer 110. In addition, the first inclination of the side surface of the first electrode part 121 with respect to the upper surface TS of the insulating layer 110 may be different from the second inclination of the side surface of the second electrode part 122 with respect to the upper surface TS of the insulating layer 110.

The third electrode part 123 may be disposed between the first electrode part 121 and the second electrode part 122. The third electrode part 123 may have a third inclination different from the first inclination of the first electrode part 121 and the second inclination of the second electrode part 122. The third inclination may mean an inclination of a side surface of the third electrode part 123 with respect to the lower surface BS of the insulating layer 110. Alternatively, the third inclination may mean an inclination of the side surface of the third electrode part 123 with respect to the upper surface TS of the insulating layer 110.

In conclusion, the third inclination of the side surface of the third electrode part 123 with respect to the lower surface BS of the insulating layer 110 may be different from the first inclination of the side surface of the first electrode part 121 with respect to the lower surface BS of the insulating layer 110 and the second inclination of the side surface of the second electrode part 122 with respect to the lower surface BS of the insulating layer 110. In addition, the third inclination of the side surface of the third electrode part 123 with respect to the upper surface TS of the insulating layer 110 may be different from the first inclination of the side surface of the first electrode part 121 with respect to the upper surface TS of the insulating layer 110 and the second inclination of the side surface of the second electrode part 122 with respect to the upper surface TS of the insulating layer 110.

Accordingly, the side surface of the through electrode 120 according to the embodiment may include a plurality of inflection portions. For example, the side surface of the through electrode 120 may include a first inflection portion formed at a boundary between the first electrode part 121 and the third electrode part 123, and a second inflection portion formed at a boundary between the second electrode part 122 and the third electrode part 123.

Meanwhile, the first electrode part 121, the second electrode part 122, and the third insulating part 113 of the through electrode 120 as described above may be formed to pass through each insulating part of the insulating layer 110.

For example, the insulating layer 110 may include a through hole TH in which the through electrode 120 is disposed.

Specifically, the first insulating part 111 of the insulating layer 110 may include a first hole part TH1 of the through hole TH in which the first electrode part 121 is disposed. In addition, the first hole part TH1 may have a shape corresponding to the first electrode part 121. For example, the first hole part TH1 may be disposed adjacent to the lower surface of the insulating layer 110, and may gradually decrease in width toward the upper surface TS of the insulating layer 110. For example, an inner wall of the first hole part TH1 may have an inclination corresponding to the first inclination of the first electrode part 121.

Also, the second insulating part 112 of the insulating layer 110 may include a second hole part TH2 of the through hole TH in which the second electrode part 122 is disposed. In addition, the second hole part TH2 may have a shape corresponding to the second electrode part 122. For example, the second hole part TH2 may be disposed adjacent to the upper surface of the insulating layer 110 and may gradually increase in width toward the upper surface TS of the insulating layer 110. For example, an inner wall of the second hole part TH2 may have an inclination corresponding to the second inclination of the second electrode part 122.

Also, the third insulating part 113 of the insulating layer 110 may include a third hole part TH3 of the through hole TH in which the third electrode part 123 is disposed. In addition, the third hole part TH3 may have a shape corresponding to the third electrode part 123. For example, the third hole part TH3 may be disposed between the first hole part TH1 and the second hole part TH2, and may have a different inclination from the first hole part TH1 and the second hole part TH2. For example, the inner wall of the third hole part TH3 may have an inclination corresponding to the third inclination of the third electrode part 123.

Meanwhile, the first hole part TH1 and the second hole part TH2 may be one of a machining hole, a laser machining hole, and a chemical machining hole formed in the first insulating part 111 and the second insulating part 112, in order to arrange the first electrode part 121 and the second electrode part 122. In addition, the first electrode part 121 and the second electrode part 122 may be formed by filling the inside of the first hole part TH1 and the second hole part TH2 with a conductive material. For example, the inside of the first hole part TH1 and the second hole part TH2 may be filled through a plating process. That is, the first hole part TH1 and the second hole part TH2 may be formed by any one of processing methods, such as mechanical processing, laser processing, and chemical processing. When the via hole is formed by machining, methods such as milling, drilling, and routing can be used, and when the via hole is formed by laser processing, a UV or CO2 laser method can be used, and when the via hole is formed by chemical processing, a chemical containing aminosilane, ketones, etc. may be used. Accordingly, the first insulating part 111 and the second insulating part 112 may be opened.

Meanwhile, the laser processing is a cutting method that concentrates optical energy on a surface to melt and evaporate a part of the material to take a desired shape, accordingly, complex formations by computer programs can be easily processed, and even composite materials that are difficult to cut by other methods can be processed. In addition, the laser processing has a cutting diameter of at least 0.005mm, and has a wide range of possible thicknesses. As the laser processing drill, it is preferable to use a YAG (Yttrium Aluminum Garnet) laser, a CO2 laser, or an ultraviolet (UV) laser. YAG laser is a laser that can process both copper foil layers and insulating layers, and CO2 laser is a laser that can process only insulating layers.

Accordingly, the first electrode part 121 filled in the first hole part TH1 may have a trapezoidal shape in which the width W1 of the upper surface is smaller than the width W2 of the lower surface, and the second electrode part 122 filled in the second hole part TH2 may have a trapezoidal shape in which the width W3 of the upper surface is greater than the width W4 of the lower surface. For example, the first electrode part 121 and the second electrode part 122 may have mutually symmetrical shapes with respect to the third electrode part 123, but the embodiment is not limited thereto.

Meanwhile, the third hole part TH3 may be formed by the third electrode part 123 differently from the first hole part TH1 and the second hole part TH2. For example, the third insulating part 113 in the circuit board of the embodiment is disposed to surround the third electrode part 123 in a state in which the third electrode part 123 is formed. Accordingly, the third insulating part 113 may have a third hole part TH3 corresponding to the third electrode part 123.

Consequently, the first hole part TH1 and the second hole part TH2 are open portions of the first insulating part 111 and the second insulating part 112 to form the first electrode part 121 and the second electrode part 122. In addition, the third hole part TH3 is a portion formed by arranging the third insulating part 113 surrounding the already completed third electrode part 123. In this case, the third electrode part 123 is formed by a post plating process, and accordingly, the width W5 of the lower surface and the width W6 of the upper surface may be substantially the same. For example, the width W6 of the upper surface of the third electrode part 123 may satisfy a range of 95% to 105% of the width W5 of the lower surface of the third electrode part 123.

Meanwhile, a width of a portion of the first electrode part 121 closest to the third electrode part 123 may be smaller than a width of the third electrode part 123. For example, the width W1 of the upper surface of the first electrode part 121 may be smaller than the width W5 of the lower surface or the width W6 of the upper surface of the third electrode part 123.

Also, a width of a portion of the second electrode part 122 closest to the third electrode part 123 may be smaller than a width of the third electrode part 123. For example, the width W4 of the lower surface of the second electrode part 122 may be smaller than the width W6 of the upper surface or the width W5 of the lower surface of the third electrode part 123.

Correspondingly, a width of a portion of the first hole part TH1 that is closest to the third hole part TH3 may be smaller than a width of the third hole part TH3. In addition, a width of a portion of the second hole part TH2 that is closest to the third hole part TH3 may be smaller than a width of the third hole part TH3.

Meanwhile, the first pattern layer 130 is disposed on the lower surface BS of the insulating layer 110 of the embodiment, and the second pattern layer 140 is disposed on the upper surface TS of the insulating layer 110. The first pattern layer 130 and the second pattern layer 140 may include at least one pad connected to the through electrode 120 and a trace connected to the pad. For example, the first pattern layer 130 may include a first pad connected to the lower surface of the through electrode 120 (eg, the lower surface of the first electrode part 121). For example, the second pattern layer 140 may include a second pad connected to the upper surface of the through electrode 120 (eg, the upper surface of the second electrode part 122.

The first pad of the first pattern layer 130 may have a width greater than that of the first electrode part 121. For example, the first pad of the first pattern layer 130 may have a width greater than the width W2 of the lower surface of the first electrode part 121. Accordingly, the first pad of the first pattern layer 130 in the embodiment is disposed to completely cover the lower surface of the first electrode part 121, and accordingly, the reliability (eg, signal transmission characteristic, heat dissipation characteristic, and shielding characteristic) of the function (eg, signal transmission, heat dissipation, or shielding) of the first pad may be improved.

The second pad of the second pattern layer 140 may have a width greater than that of the second electrode part 122. For example, the second pad of the second pattern layer 140 may have a width greater than the width W3 of the upper surface of the second electrode part 122. Accordingly, in the embodiment, the second pad of the second pattern layer 140 is disposed to completely cover the upper surface of the second electrode part 122, and accordingly, the reliability (eg, signal transmission characteristic, heat dissipation characteristic, and shielding characteristic) of the function (eg, signal transmission, heat dissipation, or shielding) of the second pad may be improved.

The first pattern layer 130 and the second pattern layer 140 may be formed of at least one metal material selected from gold (Au), silver (Ag), platinum (Pt), titanium (Ti), tin (Sn), copper (Cu), and zinc (Zn).

In addition, the first pattern layer 130 and the second pattern layer 140 may be formed of a paste or solder paste including at least one metal material selected from among gold (Au), silver (Ag), platinum (Pt), titanium (Ti), tin (Sn), copper (Cu), and zinc (Zn) having excellent bonding strength. Preferably, the first pattern layer 130 and the second pattern layer 140 may be formed of copper (Cu), which has high electrical conductivity and is relatively inexpensive.

The first pattern layer 130 and the second pattern layer 140 may be formed using additive process, subtractive process, MSAP (Modified Semi Additive Process), and SAP (Semi Additive Process) method, which is a typical printed circuit board manufacturing process possible, and a detailed description thereof will be omitted herein.

As described above, in the embodiment, when the through electrode 120 is formed on the insulating layer 110 that is a core layer having a predetermined thickness or more (for example, 300 µm or more), the insulating layer 110 is formed of a plurality of insulating parts, (eg, first to third insulating parts), and thus forming electrode parts (eg, first to third electrode parts) passing through the respective insulating parts. Accordingly, in the embodiment, it is possible to prevent problems such as voids or dimples from occurring in the through electrode 120, thereby improving the physical reliability and electrical reliability of the through electrode 120. In addition, in the embodiment, the third electrode part 123 disposed at the center among the plurality of electrode parts constituting the through electrode 120 is formed through a post plating process, and accordingly, it has a shape in which the width of the upper surface and the lower surface is substantially the same. Accordingly, in the embodiment, the area of the through electrode can be increased compared to the through electrode having an hourglass shape in the comparative example, and accordingly, the effect according to the function of the through electrode can be maximized. For example, when the through electrode has a signal shielding function, the signal shielding effect may be further improved. For example, when the through electrode has a heat dissipation function, heat dissipation characteristics may be further improved.

In addition, widths of the first electrode part 121 and the second electrode part 123 other than the third electrode part 123 of the embodiment may be increased. However, when the widths of the first electrode part 121 and the second electrode part 123 are increased, the arrangement space of the first pattern layer 130 or the second pattern layer 140 is reduced, and accordingly, the density of the circuit pattern may be reduced, and accordingly, the volume in the width direction or the length direction of the circuit board may increase. On the other hand, even if the width of the third electrode part 123 of the embodiment increases, the width of the first pattern layer 130 or the second pattern layer 140 is not affected at all. This is because the pattern layer spaced apart from the third electrode part 123 in the longitudinal direction or the width direction (horizontal direction in the drawing) does not exist as the third electrode part 123 is disposed in the center of the insulating layer 110.

Hereinafter, first to third inclinations of the first electrode part 121, the second electrode part 122, and the third electrode part 123 according to the embodiment will be described. In this case, the inclination of each inner wall of the first hole part TH1, the second hole part TH2, and the third hole part TH3 in which the first electrode part 121, the second electrode part 122, and the third electrode part 123 are disposed may correspond to first to third inclinations of the first electrode part 121, the second electrode part 122, and the third electrode part 123, respectively.

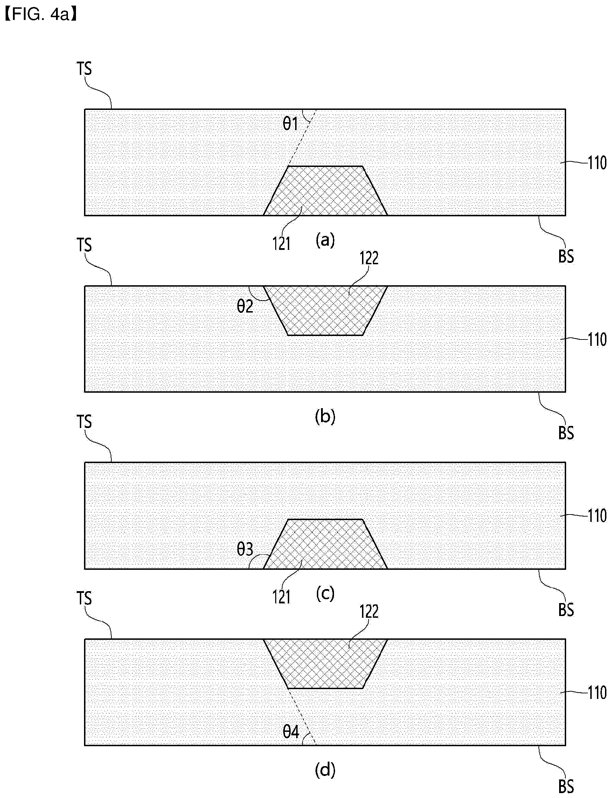

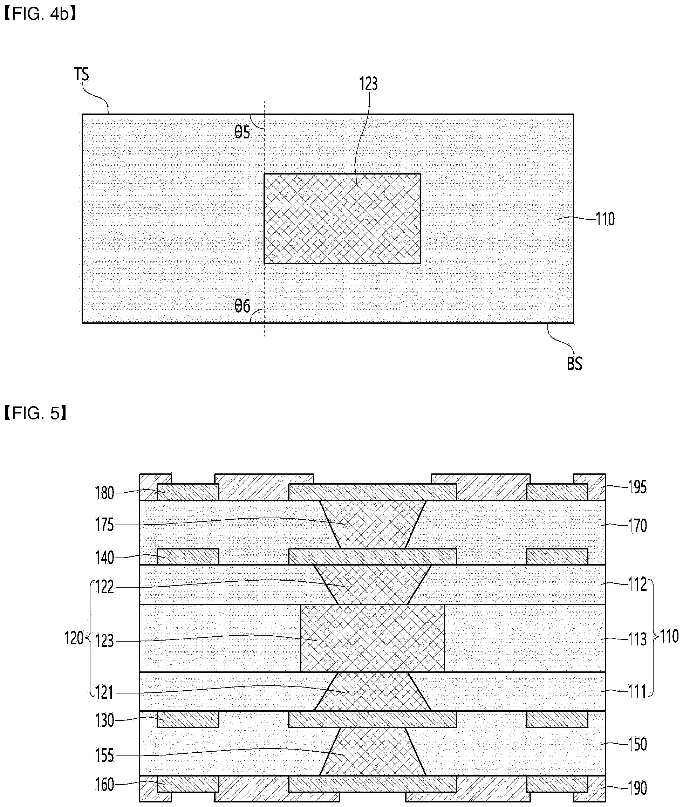

FIG. 4A is a view for explaining inclinations of side surfaces of a first electrode part and a second electrode part according to an embodiment, and FIG. 4B is a view for explaining an inclination of a side surface of a third electrode part according to an embodiment.

Hereinafter, the inclination of each side of the first electrode part 121, the second electrode part 122, and the third electrode part 123 will be described with reference to FIGS. 4A and 4B.

The first to third inclinations of side surfaces of the first electrode part 121, the second electrode part 122, and the third electrode part 123 may be an inclination with respect to the upper surface TS of the insulating layer 110, or may be an inclination with respect to the lower surface BS of the insulating layer 110.

As shown in (a) of FIG. 4A, the side surface of the first electrode part 121 may have a first inclination with respect to the upper surface TS of the insulating layer 110. For example, an inner angle θ1 between the upper surface TS of the insulating layer 110 and the side surface of the first electrode part 121 having the first inclination may be an acute angle.

Alternatively, as shown in (b) of FIG. 4A, the side surface of the second electrode part 122 may have a second inclination different from the first inclination with respect to the upper surface TS of the insulating layer 110. For example, an inner angle θ2 between the upper surface TS of the insulating layer 110 and the side surface of the second electrode part 122 having the second inclination may be an obtuse angle.

Meanwhile, as shown in (c) of FIG. 4A, the side surface of the first electrode part 121 may have a first inclination with respect to the lower surface BS of the insulating layer 110. For example, an inner angle θ3 between the lower surface BS of the insulating layer 110 and the side surface of the first electrode part 121 having the first inclination may be an obtuse angle.

Alternatively, as shown in (d) of FIG. 4A, the side surface of the second electrode part 122 may have a second inclination different from the first inclination with respect to the lower surface BS of the insulating layer 110. For example, an inner angle θ4 between the lower surface BS of the insulating layer 110 and the side surface of the second electrode part 122 having the second inclination may be an obtuse angle.

Meanwhile, as shown in FIG. 4B, the third electrode part 123 may have a third inclination different from the first inclination of the first electrode part 121 and the second inclination of the second electrode part 122.

The third inclination may mean an inclination of the side surface of the third electrode part 123 with respect to the upper surface TS of the insulating layer 110, or alternatively may mean an inclination of the side surface of the third electrode part 123 with respect to the lower surface BS of the insulating layer 110.

Specifically, a side surface of the third electrode part 123 may have a third inclination different from the first and second inclinations with respect to the upper surface TS of the insulating layer 110. For example, an inner angle θ5 between the upper surface TS of the insulating layer 110 and the side surface of the third electrode part 123 having the third inclination may be a right angle. For example, an inner angle θ6 between the lower surface BS of the insulating layer 110 and the side surface of the third electrode part 123 having the third inclination may be a right angle.

### - Circuit board of a second embodiment -

FIG. 5 is a view showing a circuit board according to a second embodiment.

The circuit board of FIG. 5 may mean a circuit board including the circuit boards of FIGS. 2 and 3 as a core layer.

For example, the circuit board may include the circuit board of FIGS. 2 and 3 as a core layer.

That is, the circuit board may have a three-layer structure based on the number of insulating layers. However, the embodiment is not limited thereto, and the circuit board may have a two-layer structure or, alternatively, may have four or more layers.

In addition, the circuit board having a multilayer structure may include the insulating layer 110 of FIG. 2 as the first insulating layer 110 serving as a core layer. In addition, the first insulating layer 110 may include first to third insulating parts 111, 112, and 113 as described above.

In addition, the circuit board may include a through electrode 120 passing through the first insulating layer 110. In addition, the through electrode 120 may include a first electrode part 121, a second electrode part 122, and a third electrode part 123 passing through each insulating part.

In addition, a first pattern layer 130 may be disposed on a lower surface of the first insulating layer 110, and a second pattern layer 140 may be disposed on an upper surface of the first insulating layer 110.

Also, the circuit board may include a second insulating layer 150 disposed under the first insulating layer 110. In this case, the second insulating layer 150 may mean a lowermost insulating layer disposed on a lowermost side of the circuit board having a multilayer structure. For example, when the circuit board has four or more layers, at least one insulating layer (not shown) and a pattern layer (not shown) may be additionally disposed between the first insulating layer 110 and the second insulating layer 150.

In addition, the circuit board may include a second through electrode 155 passing through the second insulating layer 150 and a third pattern layer 160 disposed on a lower surface of the second insulating layer 150.

In addition, the circuit board may include a third insulating layer 170 disposed on the first insulating layer 110. The third insulating layer 170 may refer to an uppermost insulating layer disposed on an uppermost side of the circuit board having a multilayer structure. For example, when the circuit board has four or more layers, at least one insulating layer (not shown) and a pattern layer 160 may be additionally disposed between the first insulating layer 110 and the third insulating layer 170.

In addition, the circuit board may include a third through electrode 175 passing through the third insulating layer 170 and a fourth pattern layer 180 disposed on the upper surface of the third insulating layer 170.

In addition, the circuit board may include a first protective layer 190 and a second protective layer 195. The first protective layer 190 and the second protective layer 195 may be substantially referred to as an insulating layer, but are referred to as a protective layer to distinguish them from the insulating layer 110.

The first protective layer 190 may be disposed on the upper surface of the second insulating layer 150 and may include an opening (not shown) exposing a portion of the lower surface of the third pattern layer 160. In addition, the second protective layer 195 may be disposed on the upper surface of the third insulating layer 170 and may include an opening (not shown) exposing a portion of the upper surface of the fourth pattern layer 180. The first protective layer 190 and the second protective layer 195 may be solder resists that protect the lower surface of the second insulating layer 150 and the upper surface of the third insulating layer 160, but is not limited thereto.

### - Circuit boards of third and fourth embodiments -

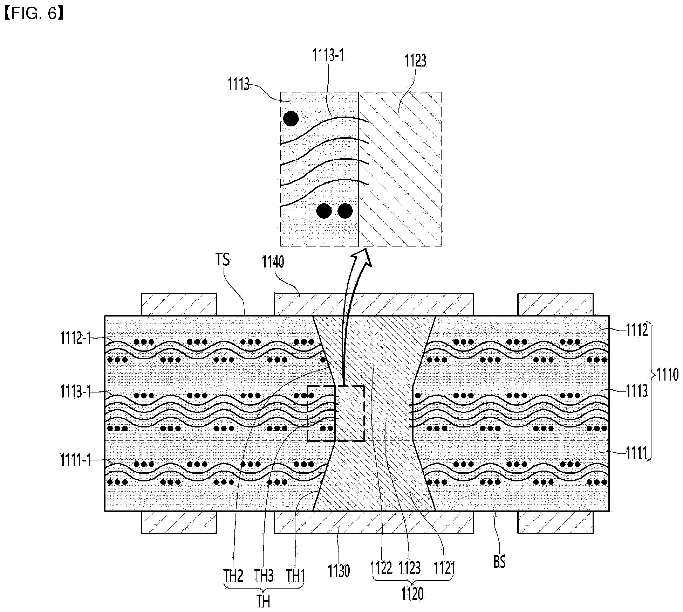

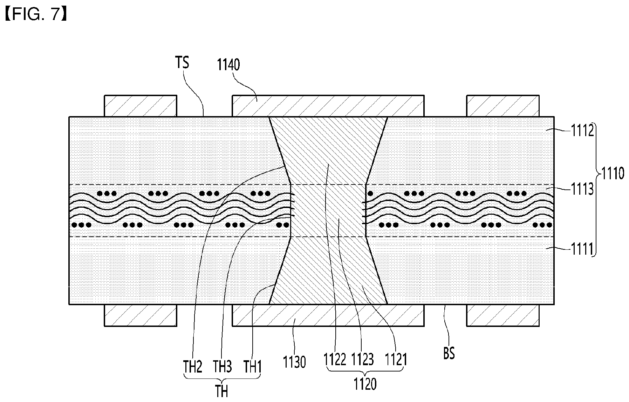

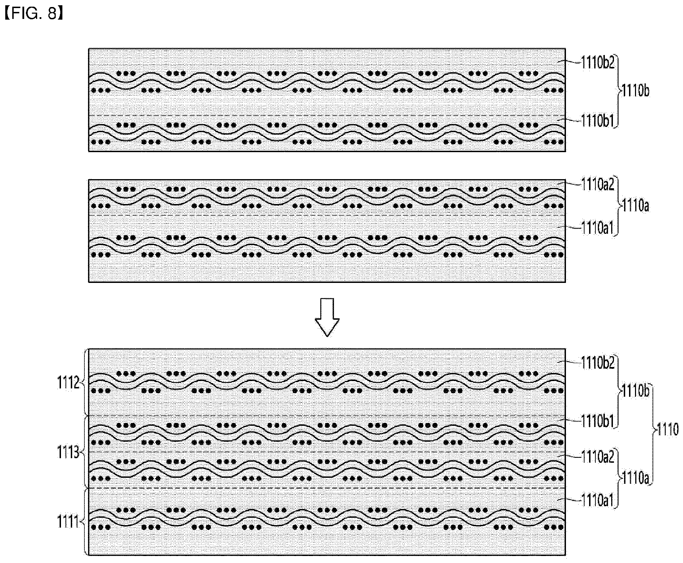

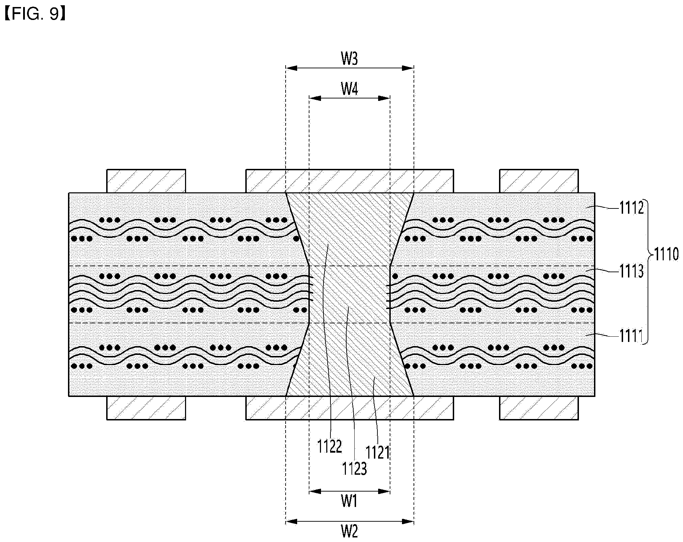

FIG. 6 is a view showing a circuit board according to a third embodiment, FIG. 7 is a view showing a circuit board according to a fourth embodiment, FIG. 8 is a view for explaining the insulating layer of FIG. 6, and FIG. 9 is a view for explaining the through electrode formed in FIG. 6 or FIG. 7.

Referring to FIGS. 6 to 9, the circuit board may include an insulating layer 1110, a through electrode 1120, a first pattern layer 1130, and a second pattern layer 1140.

The insulating layer 1110 may be a core layer. In this embodiment, although it is shown that the core layer 1110 may have the same configuration as the insulating layer 1110, the present embodiment is not limited thereto, and the insulating layer 1110 may further include a configuration other than the core layer 1110.

For example, the insulating layer 1110 may include a prepreg.

The insulating layer 1110 of the embodiment may be divided into a plurality of regions. For example, the insulating layer 1110 may be divided into a first region 1111, a second region 1112, and a third region 1113 in a thickness direction. To this end, the insulating layer 1110 may be divided into a plurality of parts in the thickness direction. However, when the insulating layer 1110 in the embodiment is divided into a plurality of parts, this is only for dividing the insulating layer 1110 into a plurality of regions in the thickness direction, and may substantially consist of one insulating layer.

For example, the insulating layer 1110 may be divided into at least three regions in the thickness direction. In addition, densities of glass fibers included in the three regions of the insulating layer 1110 may be different from each other.

For example, the insulating layer 1110 includes an upper surface (TS, Upper surface) and a lower surface (BS, Lower surface). In addition, a first pattern layer 1130 and a second pattern layer 1140 may be disposed on the lower surface BS and the upper surface TS of the insulating layer 1110, respectively. In addition, the insulating layer 1110 may be divided into a first region 1111 adjacent to the lower surface BS of the insulating layer 1110, a second region 1112 adjacent to the upper surface TS of the insulating layer 1110, and a third region 1113 between the first region 1111 and the second region 1112.

In addition, a density of the glass fibers in the first region 1111 may be different from a density of the glass fibers in the third region 1113. Also, a density of glass fibers in the second region 1112 may be different from the density of glass fibers in the third region 1113. For example, the density of glass fibers in the third region 1113 of the insulating layer 1110 may be greater than the density of glass fibers in each of the first region 1111 and the second region 1112.

In this case, the thicknesses of the first region 1111, the second region 1112, and the third region 1113 may be different from each other. Accordingly, each of the weight % of the glass fiber in the first region 1111 of the insulating layer 1110 and the weight % of the glass fiber in the second region 1112 may be less than the weight % of the glass fiber in the third region 1113 of the insulating layer 1110.

For example, in the embodiment, as shown in FIG. 6, a first glass fiber 1111-1 may be included in the first region 1111 of the insulating layer 1110, a second glass fiber 1112-1 may be included in the second region 1112 of the insulating layer 1110, and a third glass fiber 1113-1 may be included in the third region 1113 of the insulating layer 1110. And, in this case, the weight% of the third glass fiber 1113-1 may be greater than each of the weight% of the first glass fiber 1111-1 and the weight% of the second glass fiber 1112-1.

Alternatively, in the embodiment, as shown in FIG. 7, glass fibers may not be included in the first region 1111 and the second region 1112 of the insulating layer 1110, and may be concentrated or densely included in the third region 1113 of the insulating layer 1110.

In conclusion, in the embodiment, the insulating layer 1110 may be divided into a first region 1111, a second region 1112, and a third region 1113 in the thickness direction, and in this case, a dense region in which glass fibers are concentrated in the third region 1113 positioned in the center may be included.

Accordingly, when the through-hole of the embodiment is formed in the insulating layer 1110, the inclination of the inner wall of the through-hole in the insulating layer 1110 may be different from each other due to the difference in the density of the glass fibers. For example, in the embodiment, the density of the glass fiber is high in the third region 1113 so that the inclination of the inner wall of the through hole formed in the third region 1113 is substantially close to vertical. However, the embodiment is not limited thereto, and a vertical cross-section of the through hole formed in the third region 1113 may have a quadrangle through a method other than the density of the glass fiber.

However, in the embodiment, when glass fibers are included in each of the first region 1111, the second region 1112, and the third region 1113 of the insulating layer 1110, warpage characteristics of the circuit board may be further improved. Accordingly, as shown in FIG. 6, glass fibers may be partially included in the first region 1111 and the second region 1112 of the insulating layer 1110.

Meanwhile, the insulating layer 1110 as described above may be manufactured as shown in FIG. 8.

For example, in the embodiment, the insulating layer 1110 as shown in FIG. 6 or 7 may be formed by laminating a plurality of insulating layers. To this end, in the embodiment, the first insulating part 1110a and the second insulating part 1110b of the insulating layer 1110 may be prepared.

In this case, the first insulating part 1110a may include a first-first region 1110a1 in which glass fibers are disposed adjacent to a lower surface of the first insulating part 1110a, and a first-second region 1110a2 in which glass fibers are disposed adjacent to the upper surface of the first insulating part 1110a.

In addition, the second insulating part 1110b may include a second-first region 1110b1 in which glass fibers are disposed adjacent to a lower surface of the second insulating part 1110b, and a second-second region 1110b2 in which glass fibers are disposed adjacent to the upper surface of the second insulating part 1110b.

Further, in an embodiment, the insulating layer 1110 of FIG. 6 may be formed by thermal compression in a state in which the second insulating part 1110b is disposed on the first insulating part 1110a. For example, the insulating layer 1110 may include a first region 1111 corresponding to the first-first region 1110a1 of the first insulating part 1110a. Also, the insulating layer 1110 may include a second region 1112 corresponding to the second-second region 1110b2 of the second insulating part 1110b. In addition, the insulating layer 1110 may include a third region 1113 corresponding to the first-second region 1110a2 of the first insulating part 1110a and the second-first region 1110b1 of the second insulating part 1110b.

Accordingly, the third region 1113 of the insulating layer 1110 may include the first-second region 1110a2 including glass fibers in the first insulating part 1110a and the second-first region 1110b1 including glass fibers in the second insulating part 1110b. Accordingly, glass fibers may be densely formed in the third region 1113 of the insulating layer 1110 in the embodiment. For example, the insulating layer 1110 in the embodiment may include a third region 1113 that is a region in which glass fibers are dense. In addition, the third region 1113 may be a region or a central region between the first region 1111 adjacent to the lower surface BS of the insulating layer 1110 and the second region 1112 adjacent to the upper surface TS of the insulating layer 1110.

On the other hand, when glass fibers are also included in the first region 1111 and the second region 1112 of the insulating layer 1110, the density of the glass fibers in the third region 1113 may be at least twice the density of the glass fibers in the first region 1111 and/or the density of the glass fibers in the second region 1112. For example, the density of the glass fibers in the third region 1113 may be at least three times greater than the density of the glass fibers in the first region 1111 and/or the density of the glass fibers in the second region 1112. For example, the density of the glass fibers in the third region 1113 may be at least five times greater than the density of the glass fibers in the first region 1111 and/or the density of the glass fibers in the second region 1112.

In the embodiment, when the thickness of the insulating layer 1110 is 300 µm or more as described above, the insulating layer 1110 is divided into first to third regions in the thickness direction in order to improve the physical reliability and electrical reliability of the through electrode 1120 passing therethrough. And, in the embodiment, the glass fibers are concentrated in the third region 1113 that is the central region of the insulating layer 1110.

However, the embodiment is not limited thereto, and even when the thickness of the insulating layer 1110 is less than 300 µm, the insulating layer 1110 may be divided into three regions, and accordingly, a dense region of glass fibers may be formed in the center thereof.

However, an effect that appears as the through electrode 1120 is formed in the insulating layer 1110 including the third region 1113 in which the glass fiber of the embodiment is dense is maximized when the insulating layer 110 has a thickness of 300 µm or more. Accordingly, in the following description, it is assumed that the insulating layer 1110 has a thickness T of 300 µm or more.

The first region 1111, the second region 1112, and the third region 1113 constituting the insulating layer 1110 may have different thicknesses. For example, the first region 1111 may have a greater thickness than the third region 1113. The first region 1111 and the second region 1112 may have a thickness corresponding to each other. However, the embodiment is not limited thereto. For example, each of the first region 1111 and the second region 1112 of the insulating layer 1110 may have a smaller thickness than the third region 1113.

The first region 1111 of the insulating layer 1110 may have a first thickness in a range of 75 µm to 150 µm. For example, the first region 1111 may have a first thickness in a range of 80 µm to 130 µm. For example, the first region 1111 may have a first thickness in a range of 90 µm to 120 µm. When the thickness of the first region 1111 is less than 75 µm, the through-hole workability in the third region 1113 may be deteriorated, and accordingly, the processing time of the through-hole may increase. When the thickness of the first region 1111 exceeds 150 µm, the thickness of the third region 1113 decreases, and accordingly, the effect of increasing the area of the via hole or the area of the through electrode by the third region 1113 may be insignificant.

The second region 1112 of the insulating layer 1110 may have a second thickness corresponding to the first region 1111. For example, the second region 1112 may have a second thickness in a range of 75 µm to 150 µm. For example, the second region 1112 may have a second thickness in a range of 80 µm to 130 µm. For example, the second region 1112 may have a second thickness in a range of 90 µm to 120 µm.

Meanwhile, in an embodiment, a thickness of the third region 1113 may be greater than or smaller than a thickness of the first region 1111 and a thickness of the second region 1112. However, when the thickness of the third region 1113 is greater than the thickness of the first region 1111 and the thickness of the second region 1112, the area of the through hole and the area of the through electrode can be maximized. Accordingly, the following description will be made on the assumption that the thickness of the third region 1113 is greater than the thickness of the first region 1111 and the thickness of the second region 1112.

The third region 1113 may have a third thickness T3 greater than a first thickness of the first region 1111 or a second thickness of the second region 1112. For example, the third region 1113 may have a third thickness in a range of 150 µm to 300 µm. For example, the third region 1113 may have a third thickness in a range of 165 µm to 280 µm. For example, the third region 1113 may have a third thickness in a range of 180 µm to 250 µm. When the thickness of the third region 1113 is less than 150 µm, the effect of increasing the area of the through hole or the through electrode by the third region 1113 may be insignificant. For example, when the area of the via hole or the area of the through electrode in the third region 1113 increases, the heat dissipation characteristic by the through electrode may be improved, and it is possible to solve defects such as voids or dimples in the through electrode. However, when the thickness of the third region 1113 decreases, there may be no significant difference in the effect of improving the heat dissipation characteristics as described above or in resolving defects compared to the comparative example.

Meanwhile, the thickness of each of the first region 1111, the second region 1112, and the third region 1113 of the insulating layer 1110 may be determined by the total thickness of the core layer.

In addition, the thickness of each of the first region 1111 and the second region 1112 is set to have a range of 35% to 65% of the thickness of the third region 1113. For example, the thickness of each of the first region 1111 and the second region 1112 may be 38% to 62% of the thickness of the third region 1113. For example, the thickness of each of the first region 1111 and the second region 1112 may be in the range of 40% to 58% of the thickness of the third region 1113. In addition, when the thickness of each of the first region 1111 and the second region 1112 is out of a range between 35% and 65% of the third region 1113, the problems as described above may occur.

The circuit board of the embodiment includes the through electrode 1120 passing through the insulating layer 1110. For example, the through electrode 1120 includes a first electrode part 1121 passing through the first region 1111 of the insulating layer 1110, a second electrode part 1122 passing through the second region 1112 of the insulating layer 1110, and a third electrode part 1123 passing through the third region 1113 of the insulating layer 1110.

Specifically, the first electrode part 1121 is disposed adjacent to the lower surface BS of the insulating layer 1110 and has a first inclination such that the width gradually decreases toward the upper surface TS of the insulating layer 1110. The first inclination may mean an inclination of a side surface of the first electrode part 1121 with respect to the lower surface BS of the insulating layer 1110. Alternatively, the first inclination may mean an inclination of a side surface of the first electrode part 1121 with respect to the upper surface TS of the insulating layer 1110.

Also, the second electrode part 1122 may be disposed on the first electrode part 1121. For example, the second electrode part 1122 may be disposed adjacent to the upper surface TS of the insulating layer 1110. The second electrode part 1122 may have a second inclination such that the width gradually increases toward the upper surface TS of the insulating layer 1110. That is, the second electrode part 1122 may have a second inclination different from the first inclination of the first electrode part 1121. The second inclination may mean an inclination of a side surface of the second electrode part 1122 with respect to a lower surface of the insulating layer 1110. Alternatively, the second inclination may mean an inclination of a side surface of the second electrode part 1122 with respect to the upper surface of the insulating layer 1110.

In other words, the first inclination of the side surface of the first electrode part 1121 with respect to the lower surface BS of the insulating layer 1110 may be different from the second inclination of the side surface of the second electrode part 1122 with respect to the lower surface BS of the insulating layer 1110. In addition, the first inclination of the side surface of the first electrode part 1121 with respect to the upper surface TS of the insulating layer 1110 may be different from the second inclination of the side surface of the second electrode part 1122 with respect to the upper surface TS of the insulating layer 1110. For example, an inclined direction of the first electrode part 1121 corresponding to the first inclination may be different from an inclined direction of the second electrode part 1122 corresponding to the second inclination.

The third electrode part 1123 may be disposed between the first electrode part 1121 and the second electrode part 1122. The third electrode part 1123 may have a third inclination different from the first inclination of the first electrode part 1121 and the second inclination of the second electrode part 1122. The third inclination may mean an inclination of a side surface of the third electrode part 1123 with respect to the lower surface BS of the insulating layer 1110. Alternatively, the third inclination may mean an inclination of the side surface of the third electrode part 1123 with respect to the upper surface TS of the insulating layer 1110.

Consequently, the third inclination of the side surface of the third electrode part 1123 with respect to the lower surface BS of the insulating layer 1110 may be different from the first inclination of the side surface of the first electrode part 1121 with respect to the lower surface BS of the insulating layer 1110 and the second inclination of the side surface of the second electrode part 1122 with respect to the lower surface BS of the insulating layer 1110. In addition, the third inclination of the side surface of the third electrode part 1123 with respect to the upper surface TS of the insulating layer 1110 may be different from the third inclination of the side surface of the third electrode part 1123 with respect to the upper surface TS of the insulating layer 1110 may be different from the first inclination of the side surface of the first electrode part 1121 with respect to the upper surface TS of the insulating layer 1110 and the second inclination of the side surface of the second electrode part 1122 with respect to the lower surface BS of the insulating layer 1110. In this case, in an embodiment, the third inclination may be perpendicular to the lower surface BS or the upper surface TS of the insulating layer 1110. Also, in another embodiment, the third inclination may have a predetermined inclination with respect to the lower surface BS or the upper surface of the insulating layer 1110. In addition, when the third inclination has a predetermined inclination with respect to the lower surface or the upper surface of the insulating layer 1110, the predetermined inclination may be different from the first inclination and the second inclination, and may be any one of an angle between the first inclination and the second inclination.

Accordingly, the side surface of the through electrode 1120 according to the embodiment may include a plurality of inflection portions. For example, the side surface of the through electrode 1120 may include a first inflection portion formed at a boundary between the first electrode part 1121 and the third electrode part 1123, and a second inflection portion formed at a boundary between the second electrode part 1122 and the third electrode part 1123.

Meanwhile, the first electrode part 1121, the second electrode part 1122, and the third region 1113 of the through electrode 1120 as described above may be formed while passing through each region of the insulating layer 1110.

For example, the insulating layer 1110 may include a through hole TH in which the through electrode 1120 is disposed.

Specifically, the first region 1111 of the insulating layer 1110 may include a first hole part TH1 of the through hole TH in which the first electrode part 1121 is disposed. In addition, the first hole part TH1 may have a shape corresponding to the first electrode part 1121. For example, the first hole part TH1 may be disposed adjacent to the lower surface of the insulating layer 1110, and may gradually decrease in width toward the upper surface TS of the insulating layer 1110. For example, an inner wall of the first hole part TH1 may have an inclination corresponding to the first inclination of the first electrode part 1121.

Also, the second region 1112 of the insulating layer 1110 may include a second hole part TH2 of the through hole TH in which the second electrode part 1122 is disposed. In addition, the second hole part TH2 may have a shape corresponding to the second electrode part 1122. For example, the second hole part TH2 may be disposed adjacent to the upper surface of the insulating layer 1110, and may gradually increase in width toward the upper surface TS of the insulating layer 1110. For example, an inner wall of the second hole part TH2 may have an inclination corresponding to the second inclination of the second electrode part 1122.

Also, the third region 1113 of the insulating layer 1110 may include a third hole part TH3 of the through hole TH in which the third electrode part 1123 is disposed. In addition, the third hole part TH3 may have a shape corresponding to the third electrode part 1123. For example, the third hole part TH3 may be disposed between the first hole part TH1 and the second hole part TH2, and may have a different inclination from the first hole part TH1 and the second hole part TH2. For example, an inner wall of the third hole part TH3 may have an inclination corresponding to the third inclination of the third electrode part 1123.

The first electrode part 1121 filled in the first hole part TH1 may have a trapezoidal shape in which the width W1 of the upper surface is smaller than the width W2 of the lower surface, and the second electrode part 1122 filled in the second hole part TH2 may have a trapezoidal shape in which the width W3 of the upper surface is greater than the width W4 of the lower surface. For example, the first electrode part 1121 and the second electrode part 1122 may have mutually symmetrical shapes with respect to the third electrode part 1123, but are not limited thereto.

Meanwhile, the third hole part TH3 is formed in the third region 1113 corresponding to a glass fiber dense region of the insulating layer 1110.

In this case, when the through-holes are formed in the general core layer, the through hole is formed as grooves are connected after the process of forming the grooves on the upper and lower sides of the core layer, respectively. Here, in the conventional core layer, the density of glass fibers is uniform in the entire region, and accordingly, the through hole formed in the core layer has an hourglass shape. Alternatively, in the embodiment, the third region 1113 of the insulating layer 1110 includes a dense region in which the glass fibers are dense. Accordingly, a rectangular through hole may be formed in the third region 1113 of the insulating layer 1110 of the embodiment, and accordingly, the overall shape of the through hole or the through electrode includes at least three inclinations (an hourglass includes two inclinations).

Meanwhile, as shown in FIG. 6, a dense region of glass fibers is included in the third region 1113, and at least a portion of the glass fibers included in the third region 1113 may be exposed into the third hole part TH3 while forming the third hole part TH3. In addition, the third electrode part 1123 filling the third hole part TH3 may be formed to cover the glass fiber exposed into the third hole part TH3. In this case, the exposed glass fibers may function to increase the roughness of the inner wall of the through hole. Based on this, in the embodiment, the bonding strength between the insulating layer 1110 and the through electrode 1120 may be improved.

Meanwhile, one side of the third hole part TH3 is connected to the first hole part TH1 and the other side is connected to the second hole part TH2. The third hole part TH3 is formed in the third region 1113 of the insulating layer 1110 in which the glass fibers are dense, and thus the width of the upper surface thereof may be the same as the width of the lower surface.

Furthermore, the width of the lower surface of the third hole part TH3 in the embodiment may be the same as the width W1 of the upper surface of the first hole part TH1. Also, the width of the upper surface of the third hole part TH3 in the embodiment may be the same as the width W4 of the lower surface of the second hole part TH2.

For example, the width of the upper surface of the third hole part TH3 may be in a range of 95% to 105% of the width of the lower surface of the third hole part TH3.

Accordingly, the width of the lower surface of the third hole part TH3 in an embodiment may be in a range of 95% to 105% of the width of the upper surface of the first hole part TH1.

Also, the width of the upper surface of the third hole part TH3 in the embodiment may be in a range of 95% to 105% of the width of the lower surface of the second hole part TH2.

For example, the width of the third hole part TH3 may be smaller than the width of a portion having a largest width in the first hole part TH1. Also, the width of the third hole part TH3 may be the same as a width of a portion having a smallest width in the first hole part TH1.

For example, the width of the third hole part TH3 may be smaller than a width of a portion having the largest width in the second hole part TH2. Also, the width of the third hole part TH3 may be the same as a width of a portion having the smallest width in the second hole part TH2.

Meanwhile, the width of the lower surface of the first hole part TH1 may correspond to the width of the lower surface of the first electrode part 1121. Also, the width of the upper surface of the first hole part TH1 may correspond to the width of the upper surface of the first electrode part 1121.

Also, the width of the upper surface of the second hole part TH2 may correspond to the width of the upper surface of the second electrode part 1122. Also, the width of the lower surface of the second hole part TH2 may correspond to the width of the lower surface of the second electrode part 1122.

Also, the width of the upper surface of the third hole part TH3 may correspond to the width of the upper surface of the third electrode part 1123. Also, the width of the lower surface of the third hole part TH3 may correspond to the width of the lower surface of the third electrode part 1123.

Meanwhile, the first pattern layer 1130 is disposed on the lower surface BS of the insulating layer 1110 according to the embodiment, and the second pattern layer 1140 is disposed on the upper surface TS of the insulating layer 1110. The first pattern layer 1130 and the second pattern layer 1140 may include at least one pad connected to the through electrode 1120 and a trace connected to the pad. For example, the first pattern layer 1130 may include a first pad connected to the lower surface of the through electrode 1120 (eg, the lower surface of the first electrode part 1121). For example, the second pattern layer 1140 may include a second pad connected to an upper surface of the through electrode 1120 (eg, an upper surface of the second electrode part 1122).

The first pad of the first pattern layer 1130 may have a width greater than that of the first electrode part 1121. For example, the first pad of the first pattern layer 1130 may have a width greater than the width W2 of the lower surface of the first electrode part 1121. Accordingly, the first pad of the first pattern layer 1130 in the embodiment is disposed to completely cover the lower surface of the first electrode part 1121, and accordingly, the reliability (eg, signal transmission characteristic, heat dissipation characteristic, and shielding characteristic) of the function (eg, signal transmission, heat dissipation, or shielding) of the first pad may be improved.

The second pad of the second pattern layer 1140 may have a width greater than that of the second electrode part 1122. For example, the second pad of the second pattern layer 1140 may have a width greater than the width W3 of the upper surface of the second electrode part 1122. Accordingly, in the embodiment, the second pad of the second pattern layer 1140 is disposed to completely cover the upper surface of the second electrode part 1122, and accordingly, the reliability (eg, signal transmission characteristic, heat dissipation characteristic, and shielding characteristic) of the function (eg, signal transmission, heat dissipation, or shielding) of the second pad may be improved.

Meanwhile, widths of the first electrode part 1121 and the second electrode part 1123 other than the third electrode part 1123 of the embodiment may be increased. However, when the widths of the first electrode part 1121 and the second electrode part 1123 are increased, the arrangement space of the first pattern layer 1130 or the second pattern layer 1140 is reduced, and accordingly, the density of the circuit pattern may be reduced, and accordingly, the volume in the width direction or the length direction of the circuit board may increase. On the other hand, even if the width of the third electrode part 1123 of the embodiment increases, the width of the first pattern layer 1130 or the second pattern layer 1140 is not affected at all. This is because the pattern layer spaced apart from the third electrode part 1123 in the longitudinal direction or the width direction (horizontal direction in the drawing) does not exist as the third electrode part 1123 is disposed in the center of the insulating layer 1110.

Meanwhile, the circuit board of the third and fourth embodiments may have a plurality of layer structures like the circuit board of the second embodiment shown in FIG. 5.

That is, the insulating layer, the pattern layer, and the through electrode disposed in the center of the circuit board of FIG. 5 may be implemented as the insulating layer, the pattern layer, and the through electrode of FIG. 6 or 7.

### - Semiconductor package -

A semiconductor package of the embodiment may include any one of the circuit boards of the first to fourth embodiments described above. Hereinafter, a semiconductor package including the circuit board of the second embodiment shown in FIG. 5 will be described. However, the embodiment is not limited thereto, and may include the circuit boards of the first embodiment, the third embodiment, and the fourth embodiment in addition to the second embodiment.

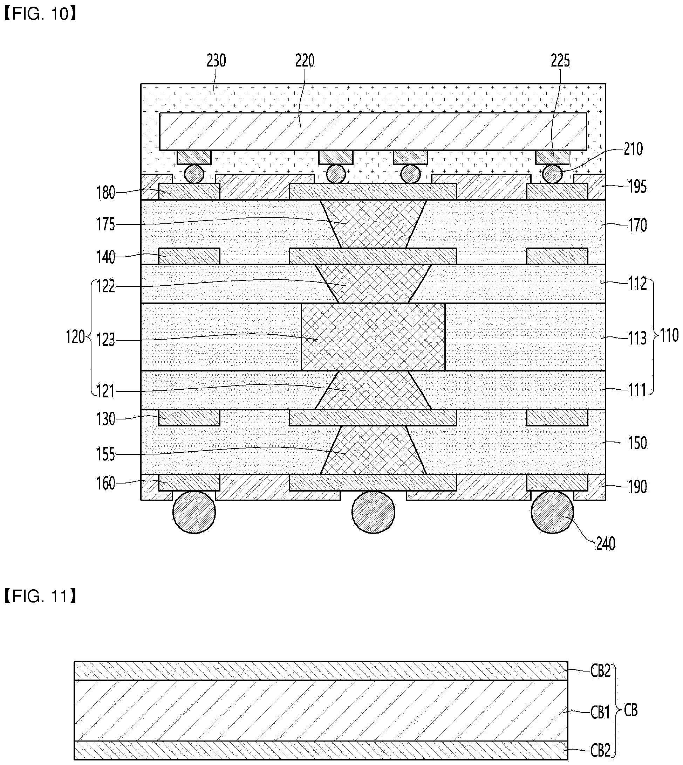

FIG. 10 is a view showing a semiconductor package according to an embodiment.

Referring to FIG. 10, the semiconductor package of the embodiment includes the circuit board of FIG. 5, at least one chip mounted on the circuit board, a molding layer for molding the chip, and a connection portion for connection to the chip or an external substrate.

For example, the semiconductor package of the embodiment may include the first connection portion 210 disposed on the fourth pattern layer 180 that is the outermost pattern layer. A cross-section of the first connection portion 210 may have a circular shape or a semicircular shape. For example, the cross-section of the first connection portion 210 may include a partially or entirely rounded shape. The cross-sectional shape of the first connection portion 210 may be a flat surface on one side and a curved surface on the other side. The first connection portion 210 may be a solder ball, but is not limited thereto.

Meanwhile, in an embodiment, the chip 220 may be disposed on the first connection portion 210. The chip 220 may be a processor chip. For example, the chip 220 may be an application processor (AP) chip of a central processor (eg, CPU), a graphic processor (eg, GPU), a digital signal processor, an encryption processor, a microprocessor, and a microcontroller. A terminal 225 of the chip 220 may be connected to the fourth pattern layer 180 through the first connection portion 210. For example, the fourth pattern layer 180 may include a mounting pad on which the chip 220 is mounted.

In addition, although not shown in the drawings, the semiconductor package according to the embodiment may further include an additional chip. For example, in an embodiment, at least two chips of a central processor (eg, CPU), a graphic processor (eg, GPU), a digital signal processor, an encryption processor, a microprocessor, and a microcontroller may be respectively arranged on the circuit board at a predetermined interval. For example, the chip 220 in the embodiment may include a central processor chip and a graphic processor chip, but is not limited thereto.

Meanwhile, the plurality of chips may be spaced apart from each other by a predetermined interval on the circuit board. For example, the interval between the plurality of chips may be 150 µm or less. For example, the interval between the plurality of chips may be 120 µm or less. For example, the interval between the plurality of chips may be 100 µm or less.

Preferably, the interval between the plurality of chips may have a range of 60 µm to 150 µm. Preferably, the interval between the plurality of chips may have a range of 70 µm to 120 µm. Preferably, the interval between the plurality of chips may have a range of 80 µm to 110 µm. When the interval between the plurality of chips is less than 60 µm, a problem in operation reliability may occur due to interference between the plurality of chips. When the interval between the plurality of chips is greater than 150 µm, as a distance between the plurality of chips increases, signal transmission loss may increase. When the spacing between the plurality of chips is greater than 150 µm, the volume of the semiconductor package may increase.

The semiconductor package may include a molding layer 230. The molding layer 230 may be disposed to cover the chip 220. For example, the molding layer 230 may be an epoxy mold compound (EMC) formed to protect the mounted chip 220, but is not limited thereto.

In this case, the molding layer 230 may have a low dielectric constant in order to improve heat dissipation characteristics. For example, the dielectric constant Dk of the molding layer 230 may be 0.2 to 10. For example, the dielectric constant Dk of the molding layer 230 may be 0.5 to 8. For example, the dielectric constant Dk of the molding layer 230 may be 0.8 to 5. Accordingly, the molding layer 230 of the embodiment has a low dielectric constant, so that heat dissipation characteristics against the heat generated by the chip 220 can be improved.

Meanwhile, the semiconductor package may include the second connection portion 240 disposed on the lowermost side of the circuit board. The second connection portion 240 may be disposed on a lower surface of the third pattern layer 160 exposed through the first protective layer 190.

### -Manufacturing method-

Hereinafter, a method of manufacturing the circuit board shown in FIG. 2 according to an embodiment will be described in order of process. However, the circuit boards of the second embodiment, the third embodiment, and the fourth embodiment may be manufactured based on the following description.

FIGS. 11 to 24 are views showing the manufacturing method of the circuit board shown in FIG. 2 in order of process.

Referring to FIG. 11, in the embodiment, a process of first forming a part of the through electrode 120 of the circuit board may be performed. For example, in the embodiment, a process of first forming the third electrode part 123 of the through electrode 120 may be performed.

To this end, in the embodiment, a carrier board CB in which a carrier insulating layer CB 1 and a metal layer CB2 are formed on at least one surface of the carrier insulating layer CB 1 may be prepared.

In this case, the metal layer CB2 may be disposed on only one of the first and second surfaces of the carrier insulating layer CB1, or alternatively, it may be disposed on both surfaces of the carrier insulating layer CB1. For example, the metal layer CB2 is disposed on only one surface of the carrier insulating layer CB1, and accordingly, the process of forming the third electrode part 123 of the through electrode 120 of the circuit board may be performed only on the one surface. Alternatively, the metal layer CB2 may be disposed on both surfaces of the carrier insulating layer CB1, and accordingly, a process of forming a plurality of third electrode parts 123 to be included in a plurality of circuit boards on both sides of the carrier board CB may be performed. In this case, two third electrode parts 123 to be included in two circuit boards may be simultaneously manufactured.

The metal layer CB2 may be formed by electroless plating on the carrier insulating layer CB1. Alternatively, the carrier insulating layer CB1 and the metal layer CB2 may be copper clad laminate (CCL).

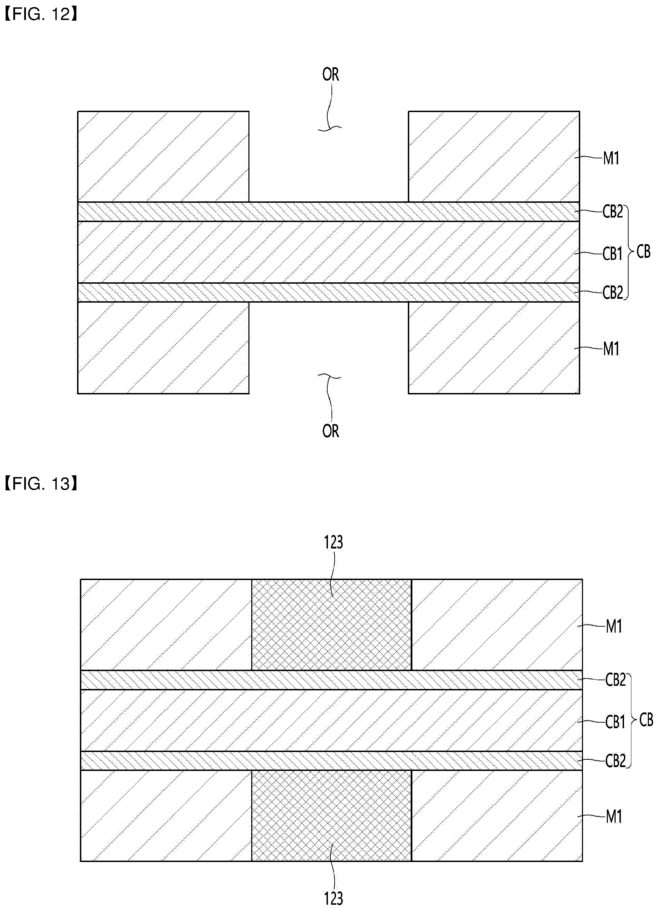

Next, referring to FIG. 12, in the embodiment, a first mask M1 is formed on the metal layer CB2. And, the first mask M1 is exposed and developed to form an opening OR exposing a region where the third electrode part 123 is to be formed. In this case, although it is illustrated that only one opening OR is included in one first mask M1, the embodiment is not limited thereto. For example, the insulating layer 110 of the embodiment may include a plurality of through electrodes spaced apart from each other in the length direction or the width direction, and accordingly, a plurality of openings may be formed in one first mask M1 to correspond thereto.

Next, referring to FIG. 13, in the embodiment, the third electrode part 123 filling the opening OR of the first mask M1 is formed by performing electrolytic plating on the metal layer (CB2) as a seed layer.

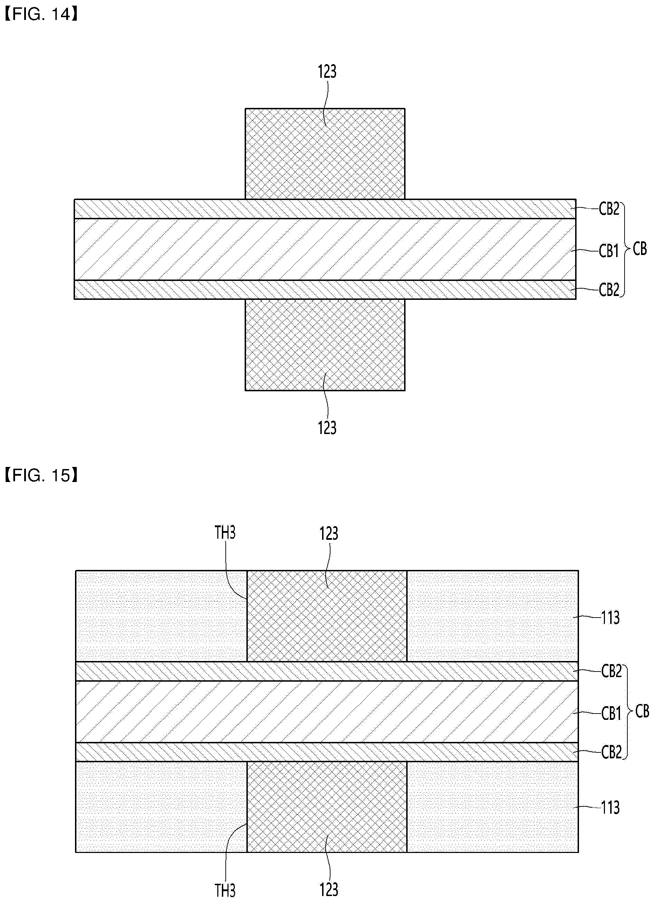

Next, referring to FIG. 14, in the embodiment, a process of removing the first mask M1 formed on the metal layer CB2 may be performed.

Next, referring to FIG. 15, in the embodiment, a process of forming the third insulating part 113 of the insulating layer 110 covering the third electrode part 123 on the metal layer CB2 may be performed. In this case, the third insulating part 113 may have the same thickness as the third electrode part 123. For example, an upper surface of the third insulating part 113 may be positioned on the same plane as an upper surface of the third electrode part 123. To this end, in the embodiment, a process may be performed such that upper surfaces of the third insulating part 113 and the third electrode part 123 are positioned on the same plane by laminating an insulating layer covering the upper surface of the third electrode part 123 on the metal layer CB2 and then performing a polishing process. Accordingly, in the embodiment, the thickness of the third insulating part 113 and the third electrode part 123 may be matched to the same thickness.

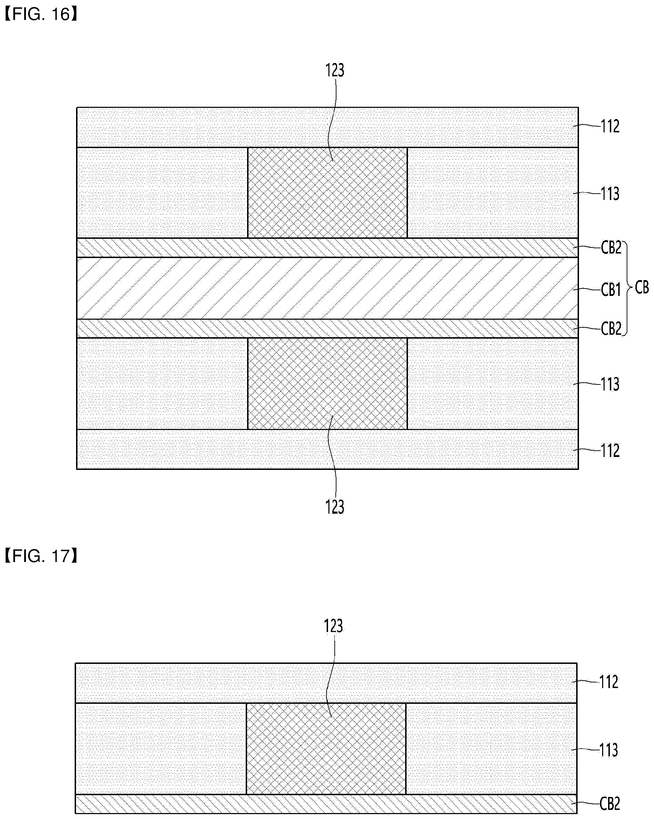

Next, referring to FIG. 16, in the embodiment, a process of laminating the second insulating part 112 on the third insulating part 113 may be performed. In this case, a copper foil layer (not shown) may be formed on the surface of the second insulating part 112 to match the lamination flatness of the second insulating part 112.

Next, referring to FIG. 17, in the embodiment, a process of separating the carrier insulating layer CB1 used to form the third electrode part 123 may be performed. In this case, the carrier board CB may further include a release film (not shown) between the carrier insulating layer CB 1 and the metal layer CB2 for easy separation of the carrier insulating layer CB 1 and the metal layer CB2.

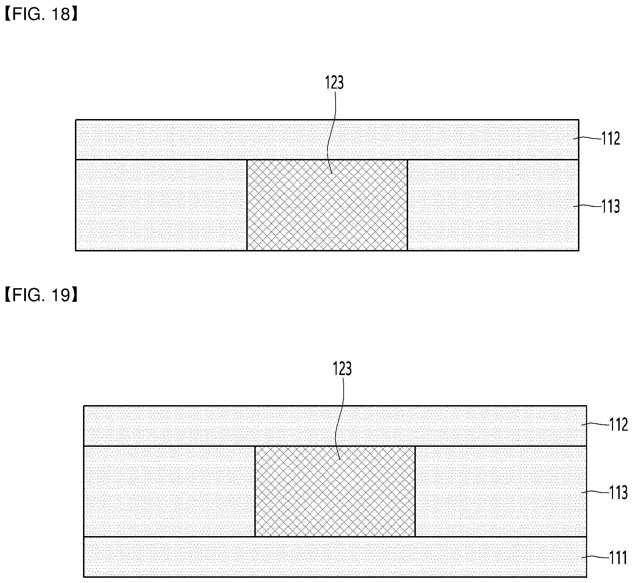

Next, referring to FIG. 18, in the embodiment, a process of etching and removing the metal layer CB2 of the carrier board CB remaining on the lower surface of the third insulating part 113 may be performed. Accordingly, a lower surface of the third insulating part 113 and a lower surface of the third electrode part 123 may be exposed.

Next, referring to FIG. 19, in the embodiment, a process of laminating the first insulating part 111 on the lower surface of the third insulating part 113 may be performed.

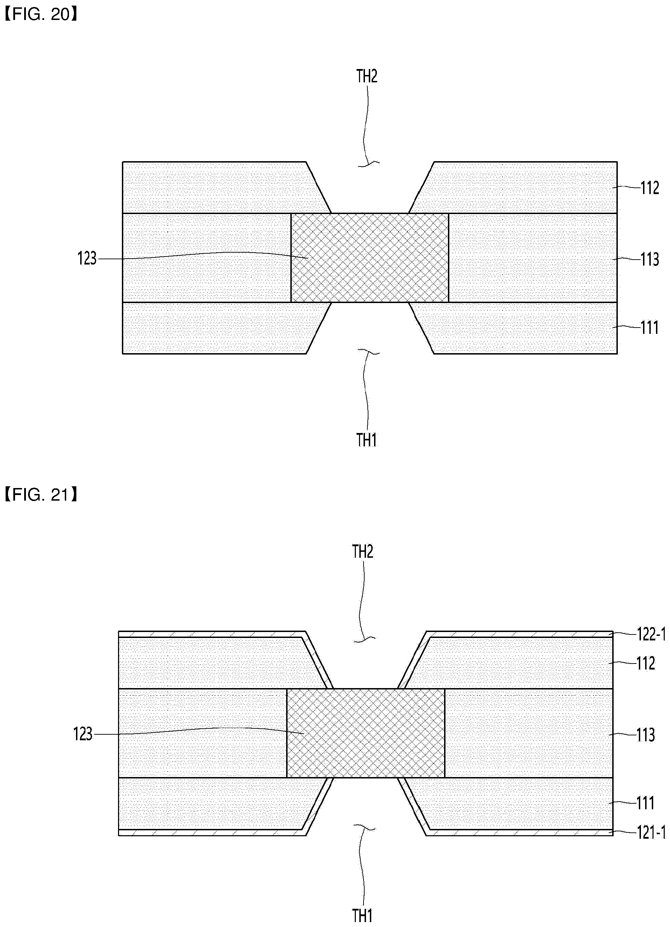

Next, referring to FIG. 20, in the embodiment, a process of forming the first hole part TH1 of the through hole TH passing through the first insulating part 111 may be performed by machining the first insulating part 111. Also, in an embodiment, a process of forming the second hole part TH2 of the through hole TH passing through the second insulating part 112 may be performed by machining the second insulating part 112.

Next, referring to FIG. 21, a process of forming a first seed layer 121-1 on a lower surface of the first insulating part 111 and an inner wall of the first hole part TH1 and a process of forming the second seed layer 122-1 on the upper surface of the second insulating part 112 and the inner wall of the second hole part TH2 may be performed.

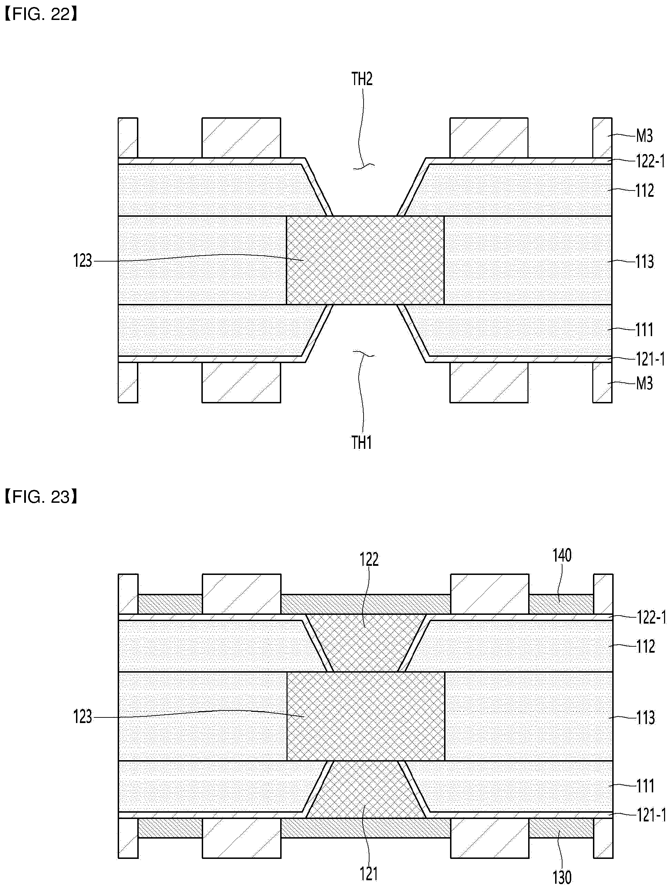

Next, referring to FIG. 22, in the embodiment, a process of forming the second mask M2 on the lower surface of the first seed layer 121-1 and a process of forming a third mask M3 on the upper surface of the second seed layer 122-1 may be performed. In this case, the second mask M2 may include an opening exposing a region where the first pattern layer 130 is to be disposed and a region where the first electrode part 121 is to be disposed among the lower surface of the first seed layer 121-1. In addition, the third mask M3 may include an opening exposing a region in which the second pattern layer 140 is to be disposed and a region in which the second electrode part 122 is to be disposed among the upper surface of the second seed layer 122-1.

Next, referring to FIG. 23, in the embodiment, a process of forming the first electrode part 121 and the first pattern layer 130 may be performed by performing electroplating using the first seed layer 121-1. In addition, in an embodiment, a process of forming the second electrode part 122 and the second pattern layer 140 may be performed by performing electrolytic plating using the second seed layer 122-1.

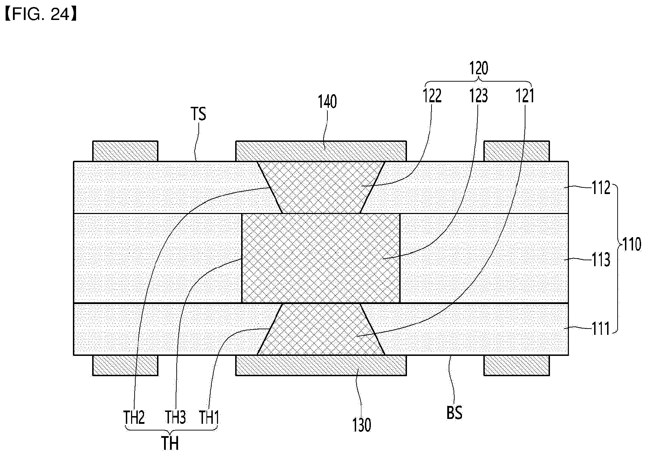

Next, referring to FIG. 24, in the embodiment, a process of removing the second mask M2 and the third mask M3 may be performed. In addition, in an embodiment, a process of removing the first seed layer 121-1 and the second seed layer 122-1 may be performed. Accordingly, in the embodiment, the first electrode part 121 and the second electrode part 122 may have a layer structure different from that of the third electrode part 123. For example, the third electrode part 123 may include only the electrolytic plating layer as the seed layer is completely removed after the plating process is performed. Alternatively, the first electrode part 121 and the second electrode part 122 may have a structure in which a part of the seed layer remains, and thus may have a two-layer structure including the seed layer and the electrolytic plating layer.

When a through electrode is formed in an insulating layer that is a core layer of a certain thickness or more (for example, 300 µm or more), the embodiment divides the insulating layer into a plurality of insulating parts (eg, first to third insulating parts), and accordingly, electrode parts (eg, first to third electrode parts) passing through each of the insulating parts are formed. In addition, after first forming the third electrode part constituting the through electrode through a post plating process, a final through electrode of the embodiment is formed by forming the first electrode part and the second electrode part on the lower and upper portions of the third electrode part, respectively. That is, the third electrode part corresponding to the center of the through electrode in the embodiment is first formed by applying the post plating method, and then the first electrode part and the second electrode part are respectively formed under and one the third electrode part. Accordingly, the embodiment may prevent an empty space not filled in the electrode portion of the through electrode from being generated. Accordingly, the embodiment prevents problems such as voids or dimples from occurring in the through electrode, thereby improving the physical reliability and electrical reliability of the through electrode.

In addition, the third electrode part disposed at the center of the plurality of electrode parts constituting the through electrode according to the embodiment is formed through a post plating process, and thus the width of the upper surface and the lower surface is substantially the same. Accordingly, the embodiment can increase the area of the through electrode compared to the through electrode having the hourglass shape of the comparative example, and thus the effect according to the function of the through electrode can be maximized. For example, when the through electrode has a signal shielding function, the signal shielding effect may be further improved. For example, when the through electrode has a heat dissipation function, heat dissipation characteristics may be further improved.

Furthermore, the glass fiber may be partially exposed in the central region of the through hole of the embodiment by including a dense region of glass fibers in the central region of the insulating layer. In addition, the through electrode of the embodiment may be formed while covering the glass fiber exposed through the through hole. In this case, the exposed glass fibers function to increase the roughness of the inner wall of the through hole, and thus, the bonding force between the insulating layer and the through electrode can be improved when the through electrode is formed. Accordingly, in the embodiment, it is possible to solve the problem that the through electrode is separated from the insulating layer due to warpage occurring in various usage environments of the circuit board, and thus the physical reliability and electrical reliability of the circuit board can be improved.

The characteristics, structures and effects described in the embodiments above are included in at least one embodiment but are not limited to one embodiment. Furthermore, the characteristics, structures, and effects and the like illustrated in each of the embodiments may be combined or modified even with respect to other embodiments by those of ordinary skill in the art to which the embodiments pertain. Thus, it should be construed that contents related to such a combination and such a modification are included in the scope of the embodiment.

The above description has been focused on the embodiment, but it is merely illustrative and does not limit the embodiment. A person skilled in the art to which the embodiment pertains may appreciate that various modifications and applications not illustrated above are possible without departing from the essential features of the embodiment. For example, each component particularly represented in the embodiment may be modified and implemented. In addition, it should be construed that differences related to such changes and applications are included in the scope of the embodiment defined in the appended claims.

## Claims

1. A circuit board comprising:
an insulating layer including an upper surface and a lower surface; and
a through electrode passing through the upper and lower surfaces of the insulating layer,
wherein the through electrode includes:
a first electrode part disposed adjacent to the lower surface of the insulating layer and having a first inclination such that a width decreases toward the upper surface of the insulating layer;
a second electrode part disposed on the first electrode part and having a second inclination such that a width increases toward the upper surface of the insulating layer; and
a third electrode part disposed between the first electrode part and the second electrode part and having a third inclination different from the first and second inclinations;
wherein a width of a portion of the first electrode part closest to the third electrode part is less than or equal to a width of the third electrode part, and
wherein a width of a portion of the second electrode part closest to the third electrode part is smaller than or equal to a width of the third electrode part.

2. A circuit board comprising:
an insulating layer including an upper surface and a lower surface, and a through hole passing through the upper surface and the lower surface,
wherein the through hole includes:
a first hole part disposed adjacent to the lower surface of the insulating layer and having a first inclination to decrease in width toward the upper surface of the insulating layer;
a second hole part disposed on the first hole part and having a second inclination to increase in width toward the upper surface; and
a third hole part disposed between the first hole part and the second hole part and having a third inclination different from the first and second inclinations;
wherein a width of a portion of the first hole part closest to the third hole part is less than or equal to a width of the third hole part, and
wherein a width of a portion of the second hole part closest to the third hole part is less than or equal to a width of the third hole part.

3. The circuit board of claim 2, further comprising:
a through electrode passing through the insulating layer and corresponding to the through hole;
wherein the through electrode includes:
a first electrode part corresponding to the first hole part;
a second electrode part corresponding to the second hole part; and
a third electrode part corresponding to the third hole part.

4. The circuit board of claim 1 or 3, further comprising:
a first pad disposed on the lower surface of the insulating layer and connected to the first electrode part; and
a second pad disposed on the upper surface of the insulating layer and connected to the second electrode part.

5. The circuit board of claim 4, wherein a width of a portion of the first electrode part closest to the first pad is smaller than a width of the first pad; and
wherein a width of a portion of the second electrode part closest to the second pad is smaller than a width of the second pad.

6. The circuit board of claim 1 or 3, wherein a width of an upper surface of the third electrode part satisfies a range of 95% to 105% of a width of a lower surface of the third electrode part.

7. The circuit board of claim 1 or 3, wherein the third inclination is perpendicular to the upper surface or the lower surface of the insulating layer.

8. The circuit board of claim 1 or 3, wherein the first electrode part and the second electrode part have a mutually symmetrical shape with respect to the third electrode part.

9. The circuit board of claim 1 or 3, wherein the first inclination the second inclination are inclined in different directions.

10. The circuit board of claim 1 or 3, wherein a thickness of the insulating layer is 300µm or more.
